(19) Europäisches Patentamt
European Patent Office
Office européen des brevets

(11) **EP 2 009 795 B1**

(12) **EUROPEAN PATENT SPECIFICATION**

(45) Date of publication and mention
of the grant of the patent:
**02.06.2010 Bulletin 2010/22**

(51) Int Cl.:
***H03K 19/003*** (2006.01)    ***H03K 17/16*** (2006.01)

(21) Application number: **07111485.4**

(22) Date of filing: **29.06.2007**

(54) **Low noise electronic circuitry**

Geräuscharme elektronische Schaltung

Circuit électronique à faible bruit

(84) Designated Contracting States:
**DE FR GB**

(43) Date of publication of application:
**31.12.2008 Bulletin 2009/01**

(73) Proprietor: **Fujitsu Microelectronics Limited
Kanagawa 222-0033 (JP)**

(72) Inventors:
• **Dedic, Ian Juso
Northolt, Middlesex UB5 5HW (GB)**

• **Mohammad, Abbas
High Wycombe, Buckinghamshire HP13 6FW
(GB)**

(74) Representative: **Wilding, Frances Ward
Haseltine Lake LLP
Lincoln House, 5th Floor
300 High Holborn
London WC1V 7JH (GB)**

(56) References cited:
**GB-A- 2 289 811        US-A- 5 477 481
US-A1- 2006 109 055**

**Description**

The present invention relates to electronic circuitry in which an effect of noise on operational performance is substantially reduced. In particular, the present invention relates to charge-packet generation circuitry for generating a series of charge packets.

Noise represents a fundamental limit in many electronic applications, particularly in signal-processing applications. As such, noise performance is a key consideration for many electronic designs. The rise in high-speed data communications has lead to a demand for ever-increasing information densities. Improvements in semiconductor processes has enabled greater data-processing speeds and functional densities to be realised, however this in turn has lead to reductions in operating supply voltage and, consequently, in signal amplitude. There is therefore an increasing need to manage noise performance in system design.

The present invention considers circuits, in particular charge-packet generation circuits, in which noise performance is critical. It is accordingly desirable to address the problem of noise performance in such circuits.

According to an embodiment of a first aspect of the present invention, there is provided a charge-packet generation circuit for generating a series of charge packets, the circuit comprising: an active electronic device whose output signal is dependent upon its input signal, whose output signal affects the size of said charge packets, and whose output signal is affected by 1/f noise (in the active electronic device) due to an effect of the 1/f noise on such dependence of the output signal on the input signal; measurement means operable to obtain a noise measure, being a measure of the effect of the 1/f noise on said dependence; and compensation means operable based upon said noise measure to influence (or control) operation of the circuit so as to tend to prevent the 1/f noise from affecting the size of said charge packets.

Such a circuit is advantageous because it addresses a noise-related problem identified in such circuits, particularly when operating speeds are increased. It has been identified that 1/f noise is a significant contributor to fluctuations in charge packet size at high operating speeds (for example because such active electronic devices are typically designed to be small in size to operate at those speeds). Accordingly, it has been found that noise performance is substantially improved by compensating for the effect of 1/f noise in this way.

Such charge packets may be considered to be charge pulses or charge bursts. The size of the packets may be defined by the amount or quantity of charge in the packets. The measurement means may for example be or comprise an electronic component operable to store the measure, such as a capacitor storing a charge (or potential difference) across its plates. The compensation means may for example comprise the same electronic component operable to store the measure, such as the capacitor storing a charge (or potential difference) across its plates. Taking this example, the capacitor may for example apply its stored charge (or potential difference) to the input of the active electronic device in order to carry out such influencing.

The effect of 1/f noise on the dependence of the output signal on the input signal could be measured by directly measuring the size of said charge packets, or by measuring another related signal. For example, the 1/f noise effect could be measured by measuring the output signal of the active electronic device, or by determining the input signal of the active electronic device required to cause the output of the active electronic device to have a predetermined level.

The compensation means may for example carry out such control by adapting the input signal of the active electronic device. Optionally, the compensation means may carry out such control by controlling operation of the active device other than by adapting the input signal. For example, if the active device is a MOSFET, the compensation means may carry out such control/influencing by varying the bulk voltage of that MOSFET.

The compensation means may for example carry out such influencing or control by adapting the output signal of the active electronic device, for example by combining the output of signal of the active electronic device with the output of another electronic device and by adapting operation of that other electronic device. The compensation means may adapt said input signal so as to tend to prevent the 1/f noise from affecting the size of said charge packets. The noise measure may be a measure of a difference between the output signal and the input signal of the active electronic device. The noise measure may be a measure of a level of the input signal of the active electronic device that causes the output signal of the active electronic device to have a predetermined level.

The active electronic device may be a transistor, for example a field-effect transistor. The compensation means may thus be operable to adapt a gate-source voltage applied between the gate and source terminals, or a gate voltage applied to the gate terminal, of the field-effect transistor so as to tend to prevent the 1/f noise from affecting the size of the charge packets. Field-effect transistors are common building blocks of electronic circuitry and experience significant 1/f noise as their gate areas are reduced. In high-speed electronic circuitry, for example operating at a clock rate of around 2.5GHz, such field-effect transistors are particularly small, such that the 1/f corner frequency for those devices may be as high as 10MHz. If such field-effect transistors are operated in saturation, they approximate a voltage-controlled current source. In that case, the gate-source voltage applied to the gate terminal effectively controls the drain current passed by that transistor. In that case, if the drain current affects the size of the charge packets, it is advantageous to adapt the gate-source voltage so as to tend to prevent the 1/f noise from affecting the size of said charge packets.

Similarly, if the source voltage when passing a predetermined drain current affects the size of the charge packets, it is advantageous to adapt the gate voltage so as to tend to prevent the 1/f noise from affecting the size of said charge packets.

The noise measure may be a measure of a gate-source voltage for said field-effect transistor at which that field-effect transistor passes a predetermined drain current when saturated. The circuit may be configured such that each said charge packet is terminated when the magnitude of the gate-source voltage for said field-effect transistor falls to a termination value from a higher value. The termination value may be a value reached after a predetermined time period from the beginning of the charge packet concerned. The compensation means may effectively ensure that the profile of the source voltage for each charge packet is substantially independent of the 1/f noise, in which case the termination value may be substantially constant from one charge packet to the next. The termination value may be a value at which the field-effect transistor passes a particular drain current. Such a drain current may be selected such that at that point the transconductance of the transistor is relatively high.

The measurement means may be operable to obtain such a noise measure during a measurement phase of operation of the circuit, and similarly the compensation means may be operable to carry out such control during a compensation phase of operation of said circuit. In that case, the compensation means may carry out such control (or influencing) in dependence upon the noise measure obtained during at least the preceding measurement phase. Optionally, the compensation means may carry out such control (or influencing) in dependence upon a series of noise measures obtained during a series of preceding measurement phases. The compensation means may carry out such control (or influencing) in dependence upon an average of, or other mathematical combination of, a plurality of noise measures obtained in preceding measurement phases. Those phases may be consecutive measurement phases or non-consecutive measurement phases and may optionally include the immediately preceding measurement phase.

The circuit preferably alternates between the measurement and compensation phases in dependence upon a control signal. The control signal may for example be a clock signal, or a signal derived therefrom. The control signal may be received from an external circuit or generated in the electronic circuit itself. The control signal may have a constant or varying frequency and may suffer from a degree of phase noise (jitter). The circuit may, for example, alternate between the measurement and compensation phases at the same frequency as that of the control signal, or at a fraction or multiple of the frequency of the control signal.

Preferably, the (electronic) circuit alternates between the measurement and compensation phases at a control frequency significantly greater than a 1/f corner frequency of the active electronic device. For example, the electronic circuit may alternate between measurement and compensation phases at a frequency 100 to 5,000 times larger than the 1/f corner frequency.

The measurement means may be configured to operate as a low-pass filter whose cut-off frequency is substantially, for example 10 to 50 times, larger than a 1/f corner frequency of the active electronic device such that the obtained noise measure tracks the effect of the 1/f noise on the dependence of the output signal of the active electronic device on its input signal. Further, the cut-off frequency is preferably substantially larger than the 1/f corner frequency and substantially smaller than said control frequency.

The cut-off frequency of the low pass filter is preferably substantially larger than the 1/f corner frequency of the electronic device and substantially smaller than the bandwidth of the electronic circuit and/or the active electronic device. The control frequency is preferably smaller than the bandwidth of the electronic circuit and/or the active electronic device.

As an embodiment of a second aspect of the present invention, the circuit may be operable alternately in charging and discharging phases. The circuit may be operable to store a charge during each charging phase and to draw a charge packet from an external circuit during each discharging phase. The output signal of such a circuit may be a current signal whose magnitude has a spike as each such charge packet is drawn from the external circuit, and the output signal of the charge pump circuit may be dependent upon the size of the charge packets such that the compensation means tends to prevent the 1/f noise from affecting the area of the spikes in the output signal of the circuit.

Preferably, the charge packets are of substantially the same size so that the area of the spikes is substantially constant from one discharging phase to the next. Accordingly, such a circuit may be used in any circuitry that requires a train of pulses having a constant area from one pulse to the next. Advantageously, such a circuit may provide such a train of pulses whose areas are substantially unaffected by 1/f noise.

The charging phase of the circuit may be or include a measurement phase and the discharging phase of the circuit may be or include a compensation phase. That is, the circuit preferably measures the effect of 1/f noise between each discharging phase, i.e. between each spike of its output signal. The circuit may, however, carry out measurement phases less frequently, for example during every other charging phase, in one charging phase out of every three or more charging phases, or in selected charging phases in dependence upon a control signal.

According to an embodiment of a third aspect of the present invention, there is provided a phase noise reduction circuit for reducing phase noise in an input pulse train consisting of pulses which are all of the same area and which, in the absence of phase noise, have a nominal frequency f, the phase noise reduction circuit comprising: DC removal means for removing a DC level from the input pulse train; integrator means for integrating the input pulse train after a DC level has been removed therefrom by the DC removal means; processing means for deriving from the integrated pulse train an output pulse train containing periodic transitions at half said nominal frequency; and a circuit according to the aforementioned second aspect of the present invention connected to the DC removal means so that its output signal provides the input pulse train.

Accordingly, it will be appreciated that the circuit (circuit X) according to the aforementioned second aspect of the present invention (also embodying the aforementioned first aspect of the present invention) of such a phase noise reduction circuit may provide as its output signal the input pulse train in which an effect of 1/f noise on that input pulse train and consequently on the output pulse train (which could otherwise occur) is reduced. That is, circuit X may produce its output signal (the input pulse train) in dependence upon a clock signal which has the nominal frequency f but which suffers from phase noise (jitter). Accordingly, the phase noise reduction circuit may produce an output pulse train based upon that input pulse train in which the phase noise is substantially reduced. However, circuit X and also the phase noise reduction circuit may operate at a high speed, at which a conventional input pulse train generator may suffer from 1/f noise. The circuit X embodying the present invention employed as the input pulse train generator of the phase noise reduction circuit may therefore provide an input pulse train in which the 1/f noise effect is reduced, therefore shielding the eventual jitter-free output pulse train from such a 1/f noise effect.

Accordingly, it will be appreciated that the present invention extends to any "high-speed" circuit that requires a low-jitter clock, for the purpose of providing such a low-jitter clock therefor in which the effect of 1/f noise is reduced. Such high-speed circuits include RF circuits, high-speed I/O (input/output) circuits, digital-to-analogue converters (DACs) and analogue-to-digital converters (ADCs). It will be appreciated that many other circuits may require such a low-jitter 1/f-noise-free clock.

According to an embodiment of a fourth aspect of the present invention, there is provided an analogue-to-digital converter (ADC) comprising a charge-packet generation circuit or a phase noise reduction circuit, as the case may be, according to the aforementioned first or third aspect of the present invention. According to an embodiment of a fifth aspect of the present invention, there is provided a digital-to-analogue converter (DAC) comprising a charge-packet generation circuit or a phase noise reduction circuit, as the case may be, according to the aforementioned first or third aspect of the present invention.

It will be appreciated that the present invention also extends to method aspects corresponding to the aforementioned circuit aspects. For example, according to an embodiment of a sixth aspect of the present invention, there is provided a method for use in a charge-packet generation circuit for generating a series of charge packets, the circuit comprising an active electronic device whose output signal is dependent upon its input signal, whose output signal affects the size of said charge packets, and whose output signal is affected by 1/f noise in the active electronic device due to an effect of the 1/f noise on such dependence of the output signal on the input signal, the method comprising: obtaining a noise measure, being a measure of the effect of the 1/f noise on said dependence; and influencing (or controlling) operation of the circuit based upon said noise measure so as to tend to prevent the 1/f noise from affecting the size of said charge packets.

Reference will now be made, by way of example, to the accompanying drawings, of which:

Figure 1 is a graph for explaining the term 1/f corner frequency;
Figure 2 is a schematic diagram of an electronic circuit 1 for understanding embodiments of the present invention;
Figure 3 is a schematic diagram for explaining the overall concept of the present invention;
Figure 4 is a circuit diagram of an electronic circuit 100 embodying the present invention, configured for a charging cycle;
Figure 5 is a circuit diagram of electronic circuit 100 configured for a discharging cycle;
Figure 6 is a schematic diagram of electronic circuit 100, used to simulate its operation;
Figures 7 and 8 are simulation results of simulation of the Figure 6 circuit;
Figure 9 is a schematic diagram for explaining the effect of 1/f noise on the electronic circuit 100;
Figure 10 presents an electronic circuit 150 that is useful for considering the operation of electronic circuit 100;
Figure 11 presents two graphs to explain how the values R and C in Figure 10 may be chosen;
Figures 12A to 12C present simulation circuits and results relating to electronic circuit 100;
Figure 13 is a circuit diagram of an electronic circuit 200 embodying the present invention, configured for a charging cycle;
Figure 14 is a circuit diagram of the electronic circuit 200, configured for a discharging cycle;
Figure 15 is a schematic diagram of the electronic circuit 200, used to simulate its operation;
Figures 16 and 17 are simulation results of simulation of the Figure 15 circuit;
Figure 18 is a schematic diagram for explaining the effect of 1/f noise on the electronic circuit 200;
Figures 19A and 19B present a simulation circuit and results relating to electronic circuit 200;
Figure 20 is a schematic diagram of an electronic circuit 300 embodying the present invention;
Figure 21 presents a frequency response of a clock signal suffering from 1/f noise; and
Figure 22 presents a problem arising from use of the Figure 21 clock signal.

In general terms, electronic noise manifests itself as an unwanted signal characteristic. There are five main sources of electronic noise, namely shot noise, thermal noise, flicker noise, burst noise and avalanche noise. In the present case, it has been appreciated that thermal noise and flicker noise are of particular importance, and those types of noise have been considered further.

Thermal noise is noise generated by the equilibrium fluctuations of electric current inside an electrical conductor, which happens regardless of any applied voltage, due to random thermal motion of electrons in the conductor. Thermal noise is spectrally flat, i.e. has a uniform power density, and is independent of current flow. Thermal noise is commonly known as white noise.

Flicker noise is a type of electronic noise with a 1/f spectrum, i.e. the frequency spectrum of flicker noise falls off steadily into higher frequencies, with a pink spectrum. Consequently, flicker noise is commonly known as 1/f noise or pink noise. Flicker noise is present in all active devices, is associated with a direct current, and has various origins. An active device is generally an electronic device that requires a source of energy for its operation and has an output that is a function of present and past input signals. Controlled power supplies, light-emitting diodes (LEDs), amplifiers, voltage-controlled oscillators (VCOs), phase-locked loops (PLLs), diodes, and transistors are common examples of active devices.

The detailed source mechanisms for the phenomenon of flicker noise are not fully known, however flicker noise in semiconductor devices is generally attributed to contaminants and defects in the crystal structure. In MOS structures, flicker noise is considered to be associated with oxide surface states that periodically trap and release carriers. Flicker noise will be referred to hereinafter as 1/f noise.

Advances in semiconductor processes and fabrication practices have generally reduced 1/f noise in semiconductor processes. However, as MOS devices become smaller in size, the effect of 1/f noise becomes more pronounced.

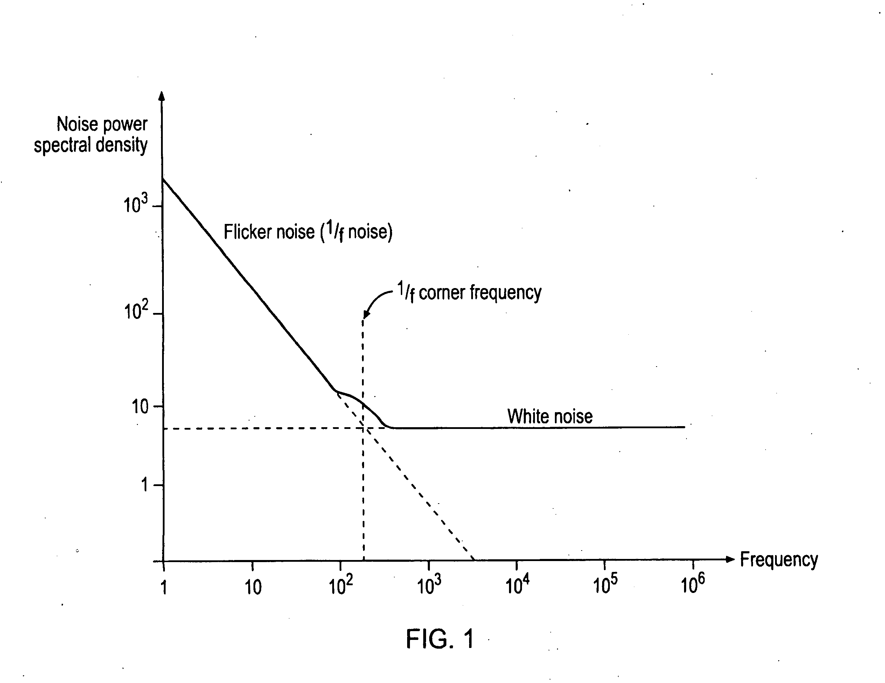

Flicker noise is generally characterised by the so-called 1/f corner frequency between the regions dominated by white noise and 1/f noise. Figure 1 is a graph for explaining the term 1/f corner frequency. As can be seen from Figure 1, the corner frequency is effectively the frequency below which a device's 1/f noise starts to exceed its thermal noise. Under "typical" operating conditions, precision bipolar processes offer the lowest 1/f corners, of around 1 to 10 Hz. The 1/f corner frequency value for devices fabricated in high-frequency bipolar processes is often 1 to 10 kHz. The 1/f corner frequency in MOSFETs is known to be inversely proportional to the square root of the channel area, with typical 1/f corner frequencies of 100 kHz to several MHz.

The present invention considers circuits, in particular charge-packet generation circuits, in which an active device is employed, and in which it has been appreciated that 1/f noise is critical to performance. For example, such circuits containing FETs that are clocked at frequencies at or exceeding 2.5GHz have been considered. In order to switch at that rate, such transistors must be made as small as possible. Consequently, such transistors have a very small gate area and accordingly 1/f noise becomes a significant problem. In transistors capable of switching at rates of 2.5GHz or more, the 1/f corner frequency may be as high as 10MHz. This means that those transistors that affect a signal output of such circuits may cause those output signals to exhibit significant 1/f noise at frequencies below the 1/f corner frequency.

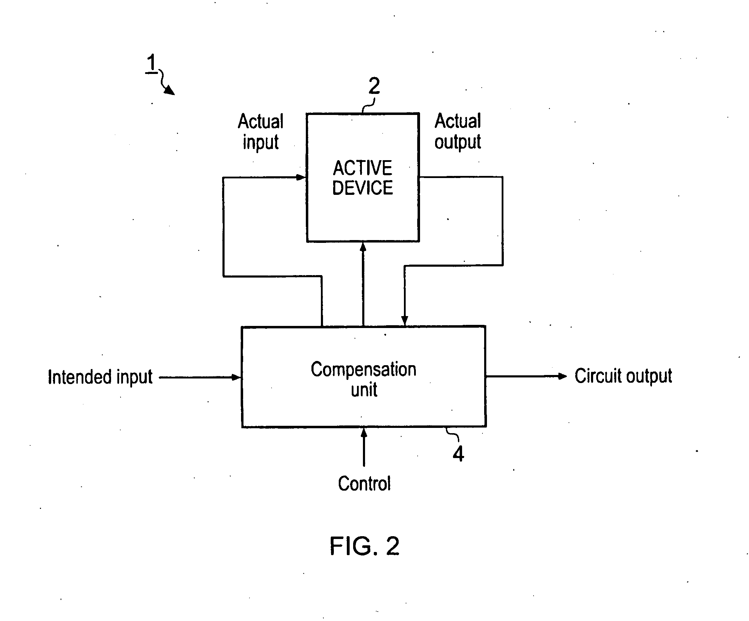

Figure 2 is a schematic diagram of an electronic circuit 1 useful for understanding embodiments of the present invention. Electronic circuit 1 comprises an active device 2 and a compensation unit 4.

Compensation unit 4 is connected to receive an intended input signal, which signal may be assumed to be an input signal which is intended to be input to the active device 2. Compensation unit 4 is further connected to supply an actual input signal to the active device 2 and to receive an actual output signal from the active device 2. Compensation unit 4 is further connected to receive a control signal to control its operation. Compensation unit 4 is operable to output a circuit-output signal in place of the actual output signal of the active device 2.

In use, compensation unit 4 adapts one or more of the input signal applied to the active device 2, the output signal output by the active device 2, and a property of the active device 2 so as to tend to reduce the effect of such 1/f noise on the circuit output signal.

During a compensation-adjustment phase, compensation unit 4 obtains a measure of an actual input signal to the active device 2 that will provide a predetermined actual output signal of the active device 2. During a subsequent compensation phase, compensation unit 4 adapts, for example, the intended input signal, in dependence upon the obtained measure. During the compensation phase, the circuit output of the compensation unit 4 may be the same as, or based upon, the actual output of the active device 2.

The control signal determines when the compensation unit 4 enters a compensation phase. The control signal may for example cause the compensation unit 4 to alternate between compensation-adjustment and compensation phases.

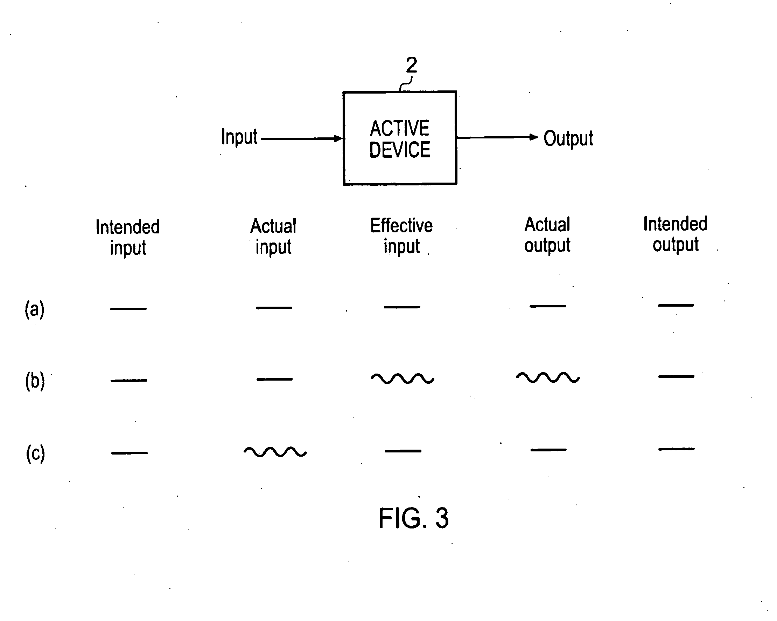

Figure 3 is a schematic diagram for explaining the overall concept of the present invention in the context of adapting the input signal of the active device. For ease of explanation, the active device 2 of Figure 2 is considered in isolation and in three different situations, namely (a), (b), and (c). As shown in Figure 3, active device 2 may be considered to receive an input signal, and to provide an output signal based on that input signal. Also for ease of explanation, a steady intended input signal is employed in each of the situations, for the purpose of achieving a steady intended output signal.

In situation (a), 1/f noise is considered to be insignificant. No 1/f-noise compensation is employed, and accordingly the intended input signal is the same as the actual input signal. Further, because 1/f noise is considered to be insignificant, the effective input signal to the active device 2 (being the input signal upon which the actual output signal is based in a 1/f-noise free active device) is the same as the actual input. That is, in each situation, the effective input signal is the input signal that would give the actual output signal in a 1/f-noise free active device. Clearly, in the present situation (a), because the active device 2 is in fact such a 1/f-noise free active device, the actual and effective input signals are the same. As can be seen from Figure 3, in this case the actual output of the active device is a steady signal, which is the intended output signal of the active device given the intended input signal.

In situation (b), 1/f noise is considered to be significant. Again, no 1/f-noise compensation is employed, and accordingly the intended input signal is the same as the actual input signal. However, because in this case 1/f noise is significant, the effective input signal is not the same as the actual input signal. Instead, the effective input signal fluctuates slowly over time due to 1/f noise, as indicated by the fluctuating line in Figure 3. That is, although a steady input signal is actually applied to the input of the active device 2, the 1/f noise manifests itself as if there was a fluctuation in that input signal, i.e. as if the actual input signal in a noise-free situation fluctuated like the effective input signal. Accordingly, the actual output signal fluctuates in dependence upon the 1/f noise, represented by the effective input signal. Significant 1/f noise is accordingly seen in the actual output signal, it not being the same as the intended output signal.

In situation (c), 1/f noise is again considered to be significant. However, in this case 1/f-noise compensation is employed. That is, in this case a compensation unit such as the compensation unit 4 of Figure 2 is employed and accordingly in this case the intended input signal is modified to form the actual input signal. The actual input signal, in this case, has been generated by modifying the intended input signal to try to compensate for the expected 1/f noise in the active device 2. The actual input signal in this case is therefore shown as a fluctuating line.

The 1/f-noise compensation employed in situation (c) is assumed to be perfect, and accordingly the effective input signal is a steady signal identical to the intended input signal. That is, although a fluctuating input signal is actually applied to the input of the active device 2, the 1/f noise effectively cancels the fluctuations in that input signal, i.e. as if the actual input signal in a noise-free situation was steady like the intended input signal. As can be seen from Figure 3, in this case the actual output of the active device is a steady signal, which is the intended output signal of the active device given the intended input signal. That is, the significant 1/f noise has thus been "shielded" from the actual output signal, i.e. the 1/f noise has been compensated for, or autozeroed.

It is emphasised that the fluctuating line used in Figure 3 is schematic only, the actual fluctuation in the relevant signal having a random nature, and therefore being difficult to predict. Accordingly, preferred embodiments of the present invention cycle between compensation-adjustment and compensation phases to effectively "track" the 1/f noise effect. Such fluctuation may occur slowly over many such cycles, for example (depending on the active device concerned) over tens or hundreds of such cycles.

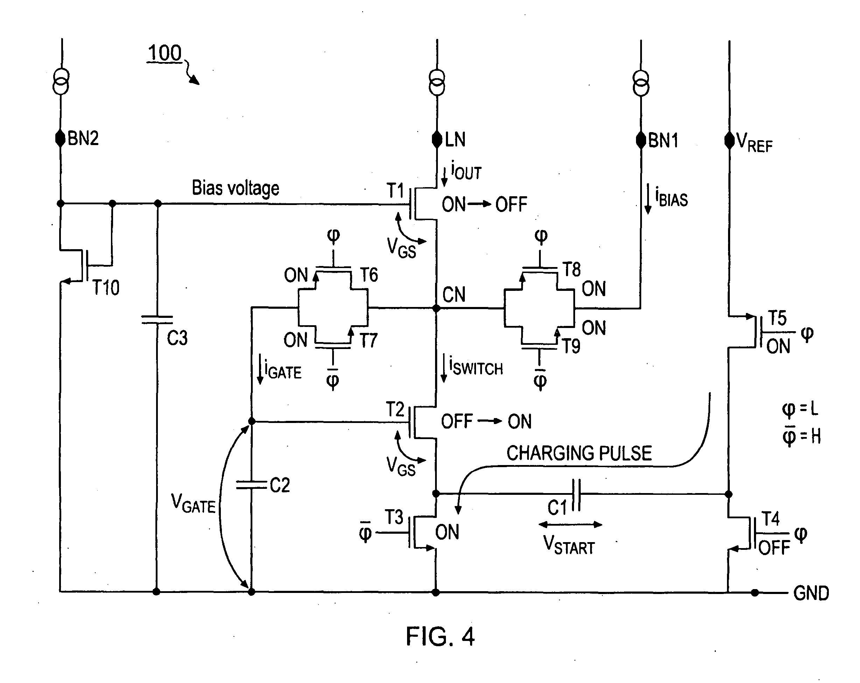

Figure 4 is a circuit diagram of an electronic circuit 100 embodying the present invention.

Electronic circuit 100 comprises MOSFETs T1 to T10, and capacitors C1 to C3. Transistors T1 to T4, T7, T9 and T10 are n-channel MOSFETs, and transistors T5, T6, and T8 are p-channel MOSFETs.

As shown in Figure 4, transistors T1 to T3 are connected in series between a load node LN and a power supply node GND, with the drain terminal of transistor T1 connected to load node LN, and the source terminal of transistor T3 connected to the power supply node GND. Transistors T5 and T4 are connected in series between a power supply node Vref and the power supply node GND, with the source terminal of transistor T5 connected to power supply node Vref, and the source terminal of transistor T4 connected to the power supply node GND.

Capacitor C1 is connected between the drain terminals of transistors T3 and T4, and capacitor C2 is connected between the gate terminal of transistor T2 and the power supply node GND.

Transistors T6 and T7 are connected in parallel with one another to form a bidirectional switch, connected between the gate terminal of transistor T2 and a cascode node CN between the drain terminal of transistor T2 and the source terminal of transistor T1 (which is a cascode transistor, as commented on below). Transistors T8 and T9 are connected in parallel with one another to form another bidirectional switch, connected between node CN and a first biasing node BN1.

Transistor T10 is connected in between a second biasing node BN2 and the power supply node GND. Transistor T10 has its gate and drain terminals connected together, such that its gate-source voltage $V_{GS}$ is equal to its drain-source voltage $V_{DS}$. In other words, the transistor T10 is a diode-connected transistor and is configured to operate in the saturated region, in which it operates predominantly as a voltage-controlled current source. The drain terminal of transistor T10 is connected to the gate terminal of transistor T1, and capacitor C3 is connected between the gate terminal of transistor T1 and the power supply node GND.

Electronic circuit 100 receives complementary clock input signals $\varphi$ and $\overline{\varphi}$. The gate terminals of transistors T4, T5, T6, and T8 are connected to receive clock input signal $\varphi$, and the gate terminals of transistors T3, T7 and T9 are connected to receive clock input signal $\overline{\varphi}$.

Electronic circuit 100 operates as a charge pump. When $\varphi = L$ the electronic circuit 100 undergoes a charging cycle, and when $\varphi = H$ the electronic circuit 100 undergoes a discharging cycle. The intended use of electronic circuit 100 is to draw a fixed size charge packet $Q_{PK}$ from an external circuit via load node LN in each discharging cycle.

The states of the circuit elements of electronic circuit 100 in the charging cycle are shown in Figure 4. The transistor T4 is off. The transistors T5 and T3 are both turned on, so that the right-hand end of capacitor C1 is conductively connected to power supply node Vref and the left-hand end of C1 is conductively connected to power supply node GND. Consequently, during the charging cycle, an amount of charge Q is stored on the plates of the capacitor C1 causing a corresponding potential difference $V_{START}$ therebetween, the value of Q and $V_{START}$ being dependent on the voltage level Vref and the capacitance of capacitor C1. For example, the voltage difference over capacitor C1 during the charging cycle may be 0.98Vref because of the voltage drops over conducting transistors T3 and T5. In that case, assuming C1 becomes fully charged, Q will be equal to 0.98 x C1 x Vref, and $V_{START}$ will be equal to 0.98Vref.

The transistors T6 and T7 are also both on during the charging cycle. Thus, the transistor T2 has its gate and drain terminals connected together, such that its gate-source voltage $V_{GS}$ is equal to its drain-source voltage $V_{DS}$. In other words, the transistor T2 is a diode-connected transistor during the charging cycle and is configured to operate in the saturated region, in which it operates predominantly as a voltage-controlled current source.

The transistors T8 and T9 are also both on during the charging cycle. A constant pre-selected current $i_{BIAS}$, for example 100μA, is supplied via the first biasing node BN1 through the transistors T8 and T9 to node CN, i.e. the drain terminal of transistor T2. Initially, when the circuit is first powered up, the gate-source voltage $V_{GS}$ of transistor T2 (and its drain-source voltage $V_{DS}$) is at zero volts and transistor T2 is off. That is, initially, the drain current of transistor T2, $i_{SWITCH}$, is zero. Accordingly, the current supplied to the first biasing node BN1 is supplied via the transistors T8 and T9, the node CN, and the transistors T6 and T7 to the capacitor C2, such that $i_{BIAS} = i_{GATE}$. The voltage across the capacitor C2, which is substantially equal to the gate-source voltage $V_{GS}$ of T2, therefore rises (or, in future charging cycles, is modified) towards a state in which the transistor T2 is turned on in the saturated region and the full amount of the 100μA biasing current $i_{BIAS}$ is flowing through the channel of transistor T2, such that $i_{SWITCH} = i_{BIAS}$. This state may not be reached in a single charging cycle (as described below), but this point will be approached in each charging cycle and in successive charging cycles the end point of each charging cycle will tend towards that state. Once that state is reached, the voltage level at the gate terminal of the transistor T2 stops rising as $i_{GATE}$ falls to zero. In any event, at the end of each charging cycle, the voltage level $V_{GATE}$ is stored in the capacitor C2.

The transistor T1 is employed as a cascode transistor. A pre-selected current is supplied via the second biasing node BN2 through the diode-connected transistor T10, such that a predetermined bias voltage appears at the gate terminal of transistor T10 and is applied to the gate terminal of the cascode transistor T1. Capacitor C3 in combination with the drain resistance of transistor T10 serve as an RC low-pass filter to stabilize the bias voltage, i.e. to filter out high frequency noise on that bias voltage.

The bias voltage level applied to the gate terminal of cascode transistor T1 is set so that it operates in the saturated region. This accordingly ensures that the output impedance of electronic circuit 100 is high, because the channel of transistor T1 is "pinched-off" when it is saturated, and because the drain terminal of transistor T1 is connected to the load node LN (at which the output of the electronic circuit 100 appears). Further, by setting the bias voltage applied to the gate terminal of T1 to a suitable value, T1 is configured such that its gate-source voltage $V_{GS}$ falls below its threshold voltage $V_T$ when the voltage level at the gate and drain terminals of T2 rises to, for example, 600mV, turning cascode transistor T1 off. This prevents the charge pump circuit from affecting a load connected to the load node LN during the charging cycle.

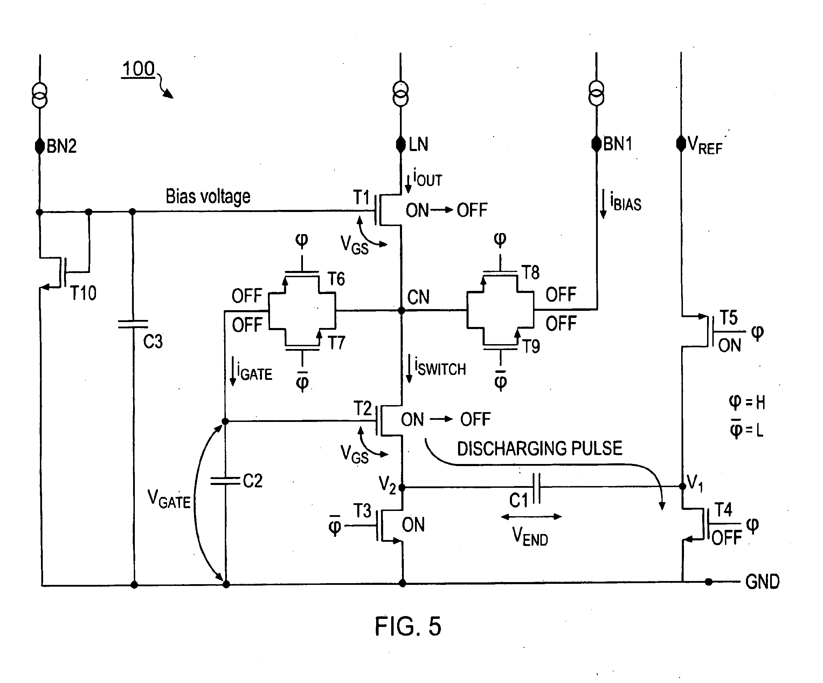

The states of the circuit elements of the electronic circuit 100 in the discharging cycle are shown in Figure 5. In the discharging cycle, the transistors T3 and T5 are turned off, the transistor T4 is turned on, and the transistors T6, T7, T8 and T9 are all turned off. Accordingly, the right-hand end of the capacitor C1 is conductively connected to the power supply node GND.

The voltage level $V_1$ at the right-hand end of capacitor C1 was substantially at Vref at the end of the preceding charging cycle, and now drops towards 0V as it is connected to the power supply node GND via transistor T4. The rate at which that voltage level drops is determined by the switching time (on time, or slew) of transistor T4.

The voltage level $V_2$ at the left-hand end of capacitor C1 which was substantially at 0V at the end of the preceding charging cycle, drops below 0V due to the effect of the charge Q which is stored in that capacitor (and the potential difference $V_{START}$ stored across its plates).

Initially, T1 is off. As already mentioned, the source terminal of transistor T2 drops below GND, and transistor T2 therefore sees its gate-source voltage $V_{GS}$ increase because the voltage level at its gate terminal $V_{GATE}$ was stored on the capacitor C2 in the preceding charging cycle and that voltage level substantially remains so stored. Accordingly, assuming the transistor T2 has reached a point at which it has turned on in the preceding charge cycle, transistor T2 remains on. This in turn causes the voltage level at node CN to decrease. Transistor T1 accordingly sees its gate-source voltage $V_{GS}$ increase too, because the bias voltage is substantially maintained at its gate terminal as mentioned above.

This gate-source voltage $V_{GS}$ increase for T1 turns it on. Accordingly, a discharging path is created from the load node LN via the transistors T1 and T2, the capacitor C1 and the transistor T4 to the power supply node GND.

Once the discharging path has been created, the stored charge Q in the capacitor C1 causes a current to flow from the load node LN to the power supply terminal GND as a packet of charge is delivered from the load node LN to the capacitor C1 returning C1 towards an uncharged state. This flowing current causes the source voltage of the transistor T2 to begin to stop dropping and instead to begin to rise. The level to which the source voltage of the transistor T2 drops is dependent on the gm value of that transistor, in combination with the on resistance of the transistor T4 already mentioned.

These values may be selected for example such that the source voltage of transistor T2 drops to around -0.6V, when Vref = 1.2V.

As already mentioned, as the packet of charge is delivered from the load node LN to the capacitor C1, the voltage level at the left-hand end of capacitor C1 (the source voltage of the transistor T2), which had dropped below 0V as mentioned above, begins to rise back towards and through 0V (GND), due to the current flow of the charge packet.

The voltage level $V_2$ at the left-hand end of C1 thus rises to the point that the gate-source voltage $V_{GS}$ for transistor T2 reduces until it is equal to its threshold voltage $V_T$, at which point transistor T2 shuts off. This terminates the flow of current and thus the charge packet.

At the point at which the charge packet is terminated, the voltage level $V_1$ at the right-hand end of capacitor C1 is substantially GND, and the voltage level $V_2$ at the left-hand end of capacitor C1 is at $V_{GATE}$, minus the gate-source voltage $V_{GS-TERM}$ for transistor T2, at which the charge packet is terminated. This voltage level $V_2$ is the source voltage of transistor T2 at charge-packet termination, hereinafter $V_{S-TERM}$. Accordingly, the potential difference $V_{END}$ across capacitor C1 at the point at which the charge packet is terminated is equal to this $V_2$.

The change in potential difference $\Delta V$ across the capacitor C1 during the discharging cycle is therefore:

$$\Delta V = V_{START} - V_{END} = V_{START} - V_2 = V_{START} - V_{S-TERM}$$

where

$$V_{S-TERM} = V_{GATE} - V_{GS-TERM}$$

The size of the charge packet $Q_{PK}$ delivered during the discharging cycle is therefore:

$$Q_{PK} = C1 \times \Delta V = C1 \times (V_{START} - V_{S-TERM})$$

Providing the discharging cycle is terminated at a constant $V_{S-TERM}$, the size of the charge packet $Q_{PK}$ will be constant assuming that C1 and $V_{START}$ remain constant. Because $V_{S-TERM} = V_{GATE} - V_{GS-TERM}$, it will later be appreciated that if $V_{GATE}$ was held constant from one cycle to the next and there was no 1/f noise present in the circuit, then the size of the charge packet $Q_{PK}$ could be considered to be constant too. It will also later be appreciated that there are different values of $V_{S-TERM}$ at which it is advantageous to terminate the charge packet.

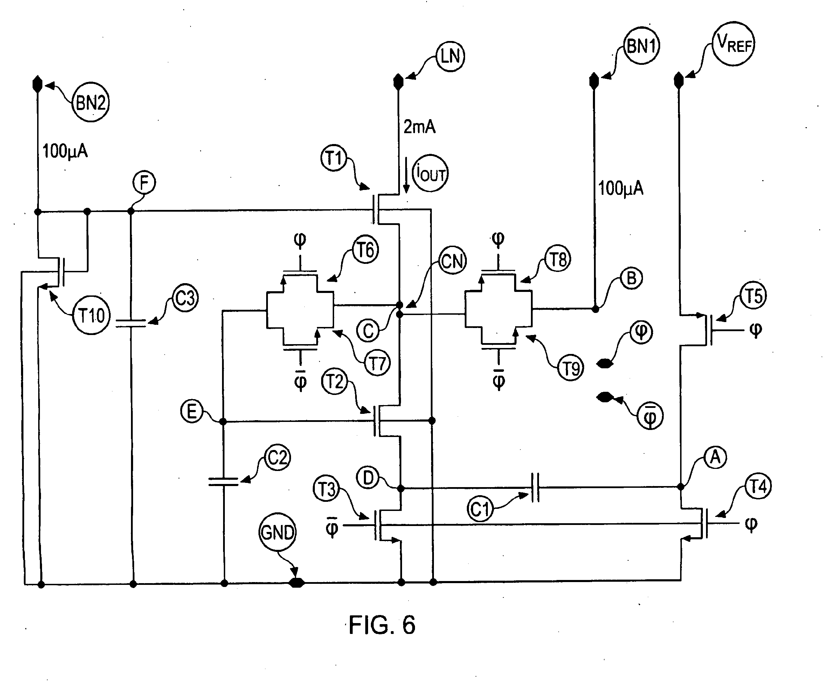

Figure 6 is a schematic diagram of the electronic circuit 100, used to simulate operation of the circuit. In order to show the correspondence between Figure 6 and Figures 4 and 5, the circuit elements and nodes in the schematic diagram of Figure 6 have been identified by circled references that correspond to the references used in Figures 4 and 5.

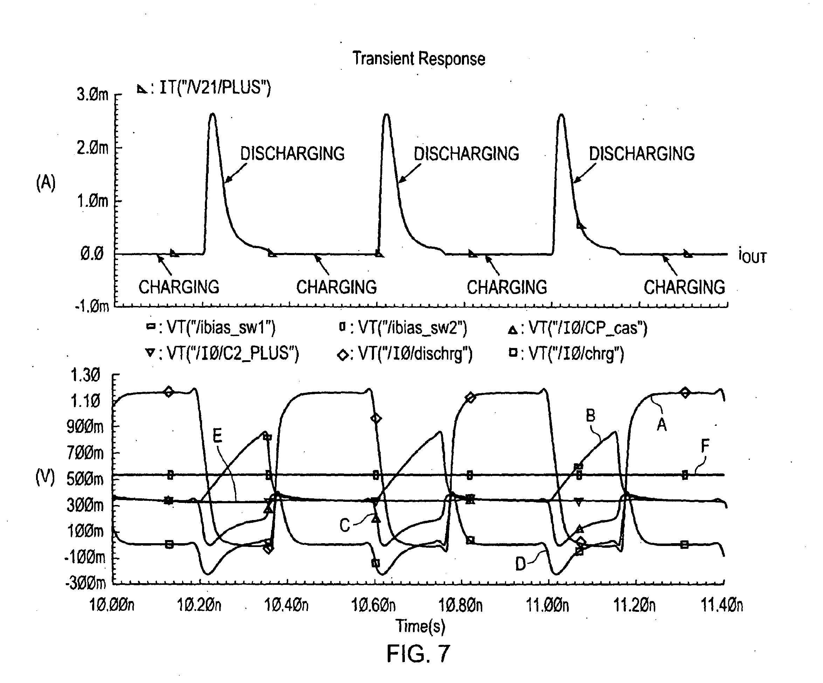

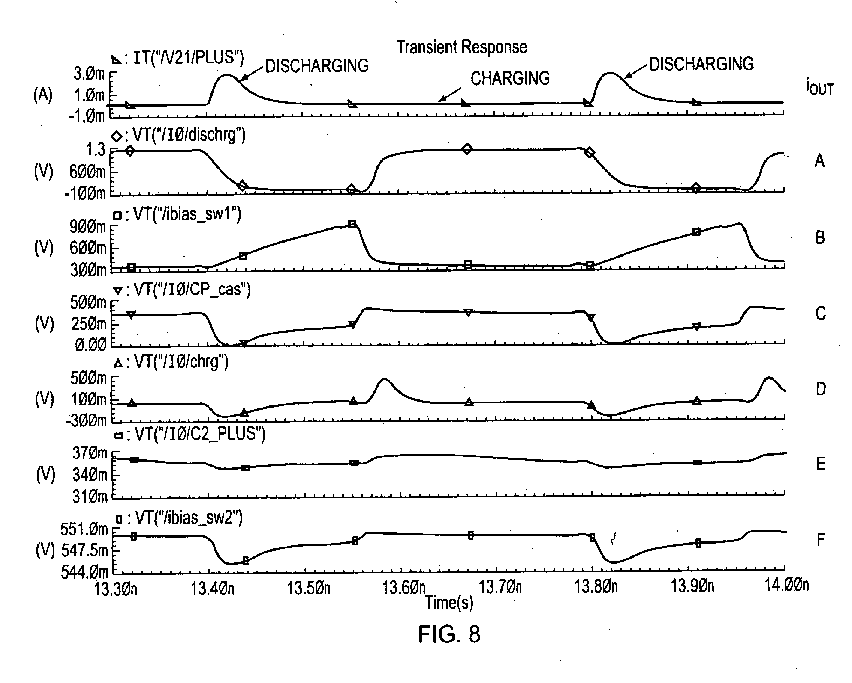

Further circled references have been entered into Figure 6 to assist understanding of Figures 7 and 8, which are discussed below. The output current is identified (as in Figure 5) by the reference $i_{OUT}$. The voltage level at the right-hand end of capacitor C1 is identified by the reference A. The voltage level at the biasing node BN1 is identified by the reference B. The voltage level at the node CN, i.e. at the drain terminal of transistor T2 and at the source terminal of transistor T1, is identified by the reference C. The voltage level at the left-hand end of capacitor C1, i.e. at the source terminal of transistor T2, is identified by the reference D. The voltage level at the gate terminal of transistor T2 is identified by the reference E. Finally, the voltage level at the gate terminal of transistor T1 is identified by the reference F.

Figures 7 and 8 show transient response simulation results for the circuit of Figure 6. The results of Figure 7 are essentially the same as the results of Figure 8, except (as can be seen from the time axis) the results of Figure 8 were taken after the results of Figure 7.

In Figure 7, the output current $i_{OUT}$ results are shown in the upper graph, and the results for voltage levels A to F are shown together on the lower graph. Accordingly, the relationship between the different voltage levels A to F as the circuit alternates between charging and discharging cycles can be seen. In Figure 8, the different results are shown on separate graphs, with the time axis at a smaller scale than in Figure 7. Accordingly, fewer cycles are shown in Figure 8 than in Figure 7, but the shapes of the different result traces over a cycle can be more clearly seen.

As can be seen from Figures 7 and 8, in each charging cycle, the voltage level A rises substantially to 1.2V (Vref for the simulation) as transistor T5 is on and transistor T4 is off. Conversely, in each discharging cycle the voltage level A falls substantially to 0V (GND for the simulation) as transistor T5 is off and transistor T4 is on. Accordingly, although the clock signals are not shown in Figures 7 and 8, the different cycles can be seen by examining trace A.

Further considering Figures 7 and 8, trace $i_{OUT}$ shows that during each charging cycle no output current flows. During each discharging cycle a spike of current flows into the circuit from the load node, as the charge packet is delivered to the capacitor C1 as already explained. The spike of current peaks at just over 2.5mA.

Traces D and C show that, at the beginning of each discharging cycle, the source voltages for the transistors T2 and T1, respectively, drop thereby creating the discharge path by turning at least transistor T1 on (T2 may simply be caused to stay on). As discussed above, the source voltage of the transistor T2 drops below ground, in this case to around -0.2V.

As can be seen from Figures 7 and 8, the electronic circuit 100 is intended to operate at a high rate. For example, it is envisaged that the input clocks $\varphi$ and $\overline{\varphi}$ may change at 2.5GHz (as in the simulation) or more. This requires each of the transistors to have a very small gate area. 1/f noise is a significant problem in small field-effect transistors, because (as already mentioned) 1/f noise is inversely proportional to the square root of gate area. In transistors capable of switching at rates of 2.5GHz or more, the 1/f corner frequency may be as high as 10MHz. This means that the transistors in the discharge path may generate significant 1/f noise at frequencies below the noise corner. The transistor T2 is particularly critical in the discharge path as (unlike the transistors T1 and T4) it is operating as an active device. The transistor T2 controls the end point of the charge packet, whereas the transistors T1 and T4 are merely acting as passive resistors.

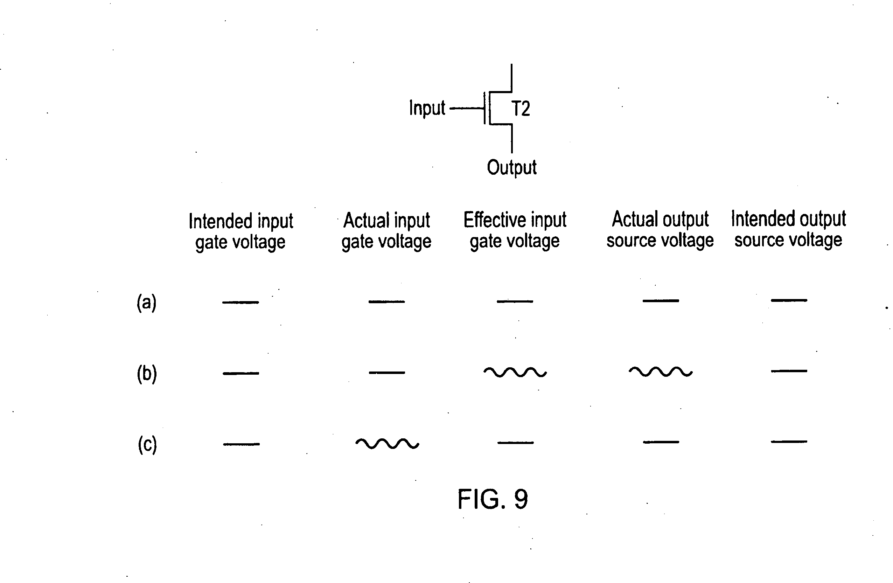

1/f noise appears in a field-effect transistor effectively as gate voltage variation, because the threshold voltage of the transistor varies with the 1/f noise. Put another way, the applied gate voltage necessary to achieve a particular source voltage in saturation while passing a predetermined drain current varies over time due to the 1/f noise. In the present case, the gate voltage variation of transistor T2 due to 1/f noise would affect the output current $i_{OUT}$ of electronic circuit 100 if the 1/f noise was not compensated for. Figure 9 is a schematic diagram for explaining the effect of 1/f noise on the electronic circuit 100. It will be appreciated that Figure 9 is closely similar to Figure 3.

For ease of explanation, the transistor T2 of electronic circuit 100 is considered in isolation and in three different situations, namely (a), (b), and (c). As shown in Figure 9, transistor T2 receives a gate voltage as an input signal, i.e. $V_{GATE}$. The relevant output signal of transistor T2 is considered to be its source voltage at the point at which the charge packet is terminated, i.e. $V_{S\text{-}TERM}$. In each situation, it is assumed that transistor T2 is passing a predetermined drain current in saturation.

As already mentioned, the intended use of electronic circuit 100 is to draw a fixed size charge packet $Q_{PK}$ from an external circuit via load node LN in each discharging cycle. As mentioned above, the size of the charge packet $Q_{PK}$ will be constant as long as the source voltage $V_{S\text{-}TERM}$ is constant, assuming that C1 and $V_{START}$ remain constant. Also as already mentioned, $V_{S\text{-}TERM} = V_{GATE} - V_{GS\text{-}TERM}$. In a 1/f-noise free transistor, it could reasonably be assumed that, to achieve a constant $V_{S\text{-}TERM}$, a constant $V_{GATE}$ from one cycle to the next can be applied to that transistor, becuase in that case the applied gate voltage necessary to achieve a particular source voltage in saturation while passing a predetermined drain current should not vary over time. That is, in the absence of 1/f noise, the voltage $V_{GS\text{-}TERM}$ necessary to pass a predetermined drain current should not vary over time. Therefore, in each of the situations (a), (b), and (c) of Figure 9, the intended input gate voltage $V_{GATE}$ is assumed to be constant over successive cycles, and the intended output source voltage $V_{S\text{-}TERM}$ similarly constant to obtain the desired fixed-size charge packet $Q_{PK}$.

In situation (a), 1/f noise is (as in Figure 3) considered to be insignificant. No 1/f-noise compensation is employed, and accordingly the intended input signal is the same as the actual input signal. Further, because 1/f noise is considered to be insignificant, the effective input signal to the transistor T2 (being the input signal upon which the actual output signal is based in a 1/f-noise free transistor) is the same as the actual input signal. As can be seen from Figure 9, in this case the actual output of the transistor T2 is a steady signal, which is the intended output signal of the transistor T2 given the intended input signal.

In situation (b), 1/f noise is considered to be significant. Again, no 1/f-noise compensation is employed, and accordingly the intended input signal is the same as the actual input signal. However, because in this case 1/f noise is significant, the effective input signal is not the same as the actual input signal. Instead, the effective input signal fluctuates relatively slowly over time due to 1/f noise, as indicated by the fluctuating line in Figure 9. That is, although a steady input signal is actually applied to the transistor T2, the 1/f noise manifests itself as gate voltage variation, i.e. as if the actual input signal in a noise-free situation fluctuated like the effective input signal. Put another way, the 1/f noise causes the voltage $V_{GS\text{-}TERM}$ necessary to pass the predetermined drain current to fluctuate, so that given a steady actual input signal the actual output signal fluctuates. Accordingly, the actual output signal fluctuates in dependence upon the effective input signal. That is, transistor T2 behaves as if it was a 1/f-noise free transistor with a fluctuating input signal. Significant 1/f noise is accordingly seen in the actual output signal, it not being the same as the intended output signal. This situation would accordingly give rise to 1/f noise being present on the size of the charge packet $Q_{PK}$ output by electronic circuit 100.

In situation (c), 1/f noise is again considered to be significant. However, in this case 1/f-noise compensation is employed. The circuitry employed to perform this compensation is discussed below, however for the present explanation it is assumed that the intended input signal is modified to form the actual input signal. The actual input signal, in this case, has been generated by modifying the intended input signal to try to compensate for the expected 1/f noise in the transistor T2. The actual input signal in this case is therefore shown as a fluctuating line. Effectively, the actual input signal $V_{GATE}$ has been caused to fluctuate to compensate for the expected fluctuation in the voltage $V_{GS-TERM}$ necessary to pass the predetermined drain current, thereby to try to obtain a constant output signal $V_{S-TERM}$.

The 1/f-noise compensation employed in situation (c) is assumed to be perfect, and accordingly the effective input signal is a steady signal identical to the intended input signal. That is, although a fluctuating input signal gate voltage is actually applied to the gate terminal of transistor T2, the 1/f noise effectively cancels the fluctuations in that input signal, i.e. as if the actual input signal in a 1/f-noise free situation was steady like the intended input signal. As can be seen from Figure 9, in this case the actual output of the transistor T2 is a steady signal, which is the intended output signal of the transistor T2 given the intended input signal. That is, the significant 1/f noise has thus been "shielded" from the actual output signal and accordingly the size of the charge packet $Q_{PK}$ output by electronic circuit 100 is constant and independent of 1/f noise.

Again, it is emphasised that the fluctuations shown may occur slowly over many cycles, for example over several hundred such cycles.

In view of the above, the electronic circuit 100 has been designed to try to operate according to situation (c) in Figure 9, i.e. to try to reduce the effect of 1/f noise in transistor T2 on the output of the circuit, i.e. on the size of the charge packet $Q_{PK}$.

In the electronic circuit 100, the gate-source voltage $V_{GS}$ of the transistor T2 is "measured" in each charging cycle. As already mentioned, during each charging cycle the voltage across the capacitor C2, which is substantially equal to the gate-source voltage $V_{GS}$ of T2 in that cycle, is modified towards a state in which the transistor T2 is turned on in the saturated region and the full amount of the $100\mu A$ biasing current $i_{BIAS}$ is flowing through the channel of transistor T2, such that $I_{SWITCH} = i_{BIAS}$. Again, this state may not be reached in a single charging cycle (as described below), but this point will be approached in each charging cycle and in successive charging cycles the end point of each charging cycle will tend towards that state. Once that state is reached in a particular such cycle, the voltage level at the gate terminal of the transistor T2 stops rising as $i_{GATE}$ falls to zero. After several cycles, that state will be closely met by the end of each cycle. In any event, at the end of each charging cycle, the voltage level $V_{GATE}$ is stored in the capacitor C2.

In the electronic circuit 100, the transistor T2 is influenced by 1/f noise which manifests itself as a gate voltage variation (or more precisely as a threshold voltage variation). By tracking a predetermined state of the transistor T2, i.e. the state in which it is turned on in the saturated region and the full amount of the $100\mu A$ biasing current $i_{BIAS}$ (i.e. a predetermined drain current) is flowing through the channel, the electronic circuit tracks the effect of 1/f noise on transistor T2. The voltage level stored in the capacitor C2 at the end of each charging cycle is a measure of this effect. That is, the voltage level stored is a measure of the gate-source voltage necessary to pass the predetermined drain current. Accordingly, by applying the voltage level $V_{GATE}$ stored on the capacitor C2 in one charging cycle as the gate voltage for transistor T2 in the following cycle, the 1/f noise in the transistor T2 is effectively compensated for and a 1/f noise impact on the charge packet size $Q_{PK}$ of the circuit (its output signal), which would otherwise occur, is reduced. That is, the shape of the current waveform of each charge packet becomes substantially independent of the 1/f noise in transistor T2.

The 1/f noise compensation employed in the electronic circuit 100 may be understood as follows. Firstly, assuming that no 1/f noise is present, the above state of the transistor T2 will be achieved over a series of cycles by a steady gate voltage $V_{GATE}$. Thus, the voltage level stored in the capacitor C2 will become substantially steady and accordingly the electronic circuit 100 will approximate situation (a) in Figure 9. Secondly, assuming now that 1/f noise is present, the above state of the transistor T2 will be achieved over a series of cycles by a correspondingly fluctuating gate voltage $V_{GATE}$, indicative of the effect of 1/f noise in transistor T2. Thus, the voltage level stored in the capacitor C2 will fluctuate and accordingly the electronic circuit 100 will approximate situation (c) in Figure 9 in which the 1/f noise is compensated for. In other words, the 1/f noise impact of T2 is "autozeroed" by the fluctuating stored gate voltage $V_{GATE}$, and the total noise on the charge packet in the discharging cycle is therefore reduced towards thermal (white) noise (kT/C).

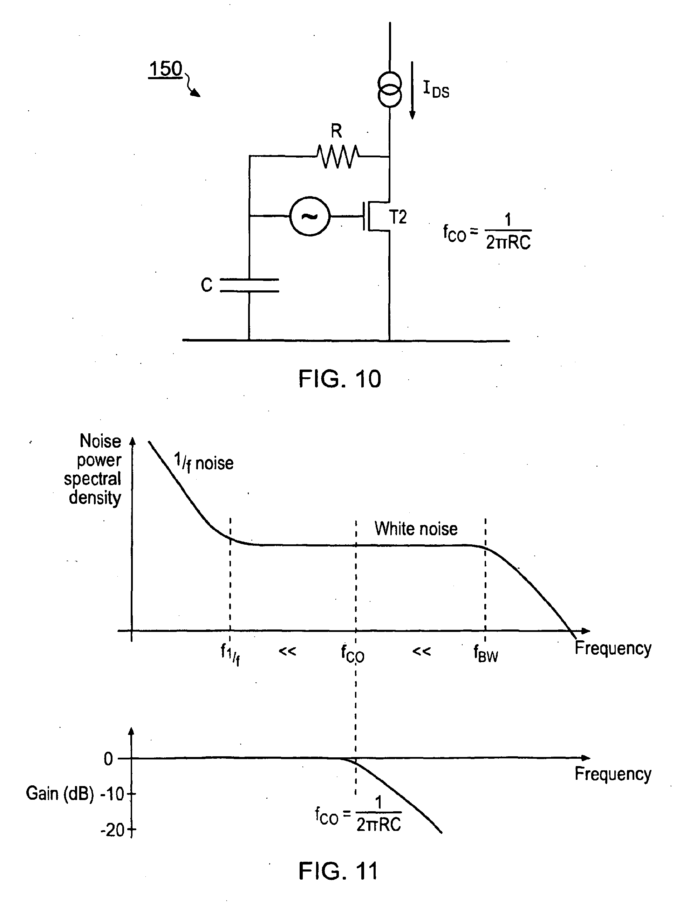

Figure 10 presents an electronic circuit 150 that is useful for considering the operation of electronic circuit 100. As already mentioned, during each charging cycle, the circuitry tracks a predetermined state of the transistor T2, namely the state in which it is turned on in the saturated region and the full amount of the $100\mu A$ biasing current $i_{BIAS}$ is flowing through the channel. In order to perform such tracking, the circuitry of electronic circuit 100 performs as a low-pass filter.

Electronic circuit 150 of Figure 10 represents the part of electronic circuit 100 that forms this low-pass filter. Accordingly, the resistance R in Figure 10 is equivalent to the on resistance of transistors T6 and T7 of electronic circuit 100, and capacitance C in Figure 10 is equivalent to the capacitance of capacitor C2 of electronic circuit 100. The cut-off frequency $f_{co}$ of this low-pass filter is accordingly:

$$f_{co} = 1/2\pi RC$$

Figure 11 presents two graphs to explain how the values R and C in Figure 10 should preferably be chosen. The upper graph shows how the noise power spectral density varies with frequency. The lower graph shows the frequency response of the low-pass filter of Figure 10.

The 1/f corner frequency is indicated as $f_{1/f}$ and below this frequency it can be seen that 1/f noise dominates over white noise. The bandwidth of the overall electronic circuit in which transistor T2 is employed is represented by $f_{BW}$. The cut-off frequency $f_{co}$ of the low-pass filter of Figure 10 is shown to be between the 1/f corner frequency $f_{1/f}$ and the bandwidth of the electronic circuit $f_{BW}$. The low-pass filter 150 is effectively used to sample the effect of 1/f noise on the transistor T2, and accordingly the cut-off frequency $f_{co}$ represents the sampling bandwidth of that circuit. Typically, the frequency at which electronic circuit 100 alternates between charging and discharging cycles (i.e. the frequency of clocks $\varphi$ and $\overline{\varphi}$) is set to be substantially larger than the sampling bandwidth $f_{co}$, and smaller than the bandwidth $f_{BW}$.

Preferably, the sampling bandwidth $f_{co}$ of circuit 150 should be a lot larger than the 1/f corner frequency $f_{1/f}$ and a lot smaller than the bandwidth $f_{BW}$ of the overall electronic circuit, in this case of electronic circuit 100. The bandwidth $f_{BW}$ is for example dependent upon the parasitic capacitances of transistor T2. The lower the sampling bandwidth $f_{co}$ of circuit 150 is set, the slower the tracking of the effect of 1/f noise on the transistor T2 will become. Accordingly, from this point of view, the larger the sampling bandwidth $f_{co}$, the better the performance of electronic circuit 100. However, as the sampling bandwidth $f_{co}$ of circuit 150 is increased, sampling noise spreads over the entire frequency bandwidth raising the thermal (white) noise level. Further, larger values of R and C are required to increase the sampling bandwidth $f_{co}$. Accordingly, in selecting the sizes and values of components T6, T7 and C2 of electronic circuit 100, a trade-off is made in view of the above criteria. By simulation, it is possible to select such sizes and values to optimise performance of electronic circuit 100.

In order to demonstrate the ability of electronic circuit 100 to compensate for the 1/f noise effect in transistor T2, simulations have been carried out as follows.

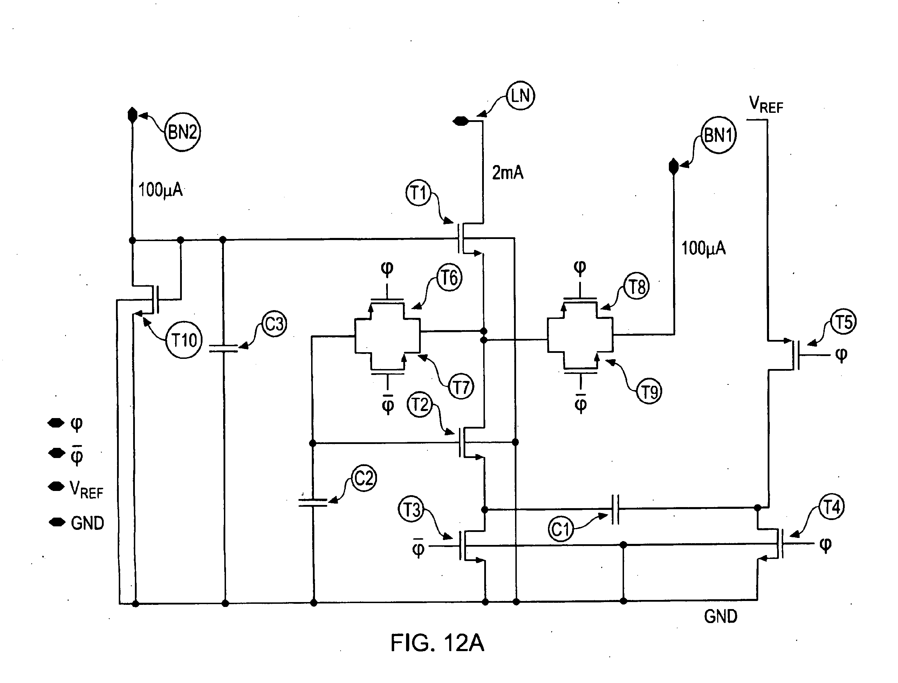

Figure 12A is a schematic diagram of the electronic circuit 100 used to simulate its operation. It will be appreciated that the schematic diagram of Figure 12A is closely similar to that of Figure 6 and accordingly the circuit elements have been labelled in the same way.

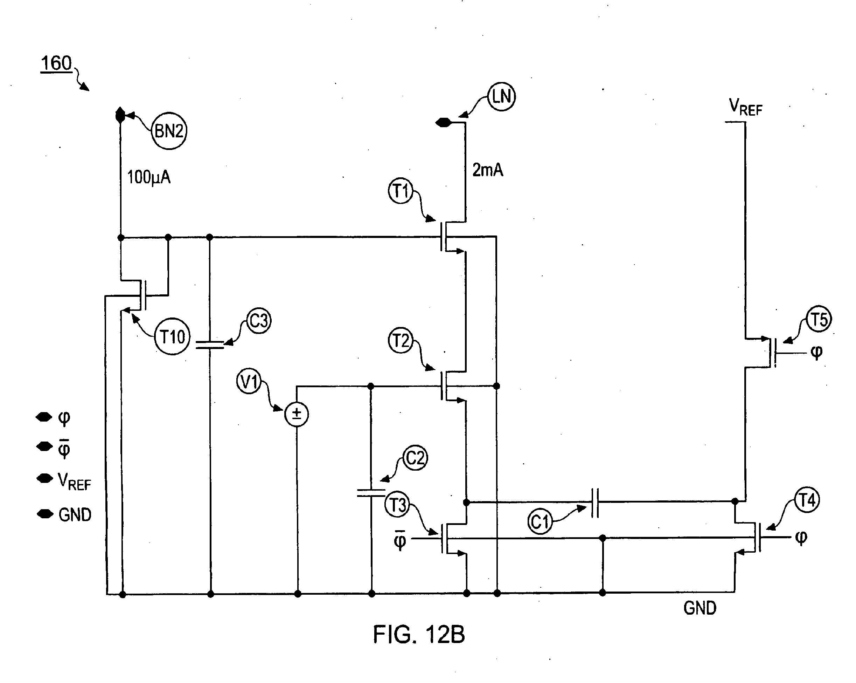

Figure 12B is a schematic diagram of an electronic circuit 160, not directly embodying the present invention. It will be appreciated that electronic circuit 160 is similar to electronic circuit 100 and accordingly those circuit elements common between the two circuits are labelled in the same way. Electronic circuit 160 differs from electronic circuit 100 in that it is not designed to compensate for the 1/f noise effect in transistor T2. Accordingly, by comparing simulations of the Figure 12A and 12B circuits it is possible to appreciate the 1/f noise compensation provided by electronic circuit 100.

As can be seen by a comparison of Figure 12B with Figure 12A, the differences between electronic circuit 160 and electronic circuit 100 are as follows. In electronic circuit 160, there is no connection to a first biasing node BN1, and consequently the bidirectional switch formed by transistors T8 and T9 is not provided. There is also no connection between the gate and drain terminals of transistor T2 in electronic circuit 160, and consequently the bidirectional switch formed by transistors T6 and T7 is also not provided. In electronic circuit 160, a voltage source V1 is connected between the gate terminal of transistor T2 and the power supply node GND, in parallel with capacitor G2.

Accordingly, in electronic circuit 160, the 1/f noise effect in transistor T2 is not tracked (as in electronic circuit 100), and instead a stable voltage level is applied to the gate terminal of transistor T2. That is, it will be appreciated that electronic circuit 160 has been designed to operate according to situation (b) in Figure 9, whereas electronic circuit 100 has been designed to operate according to situation (c) in Figure 9.

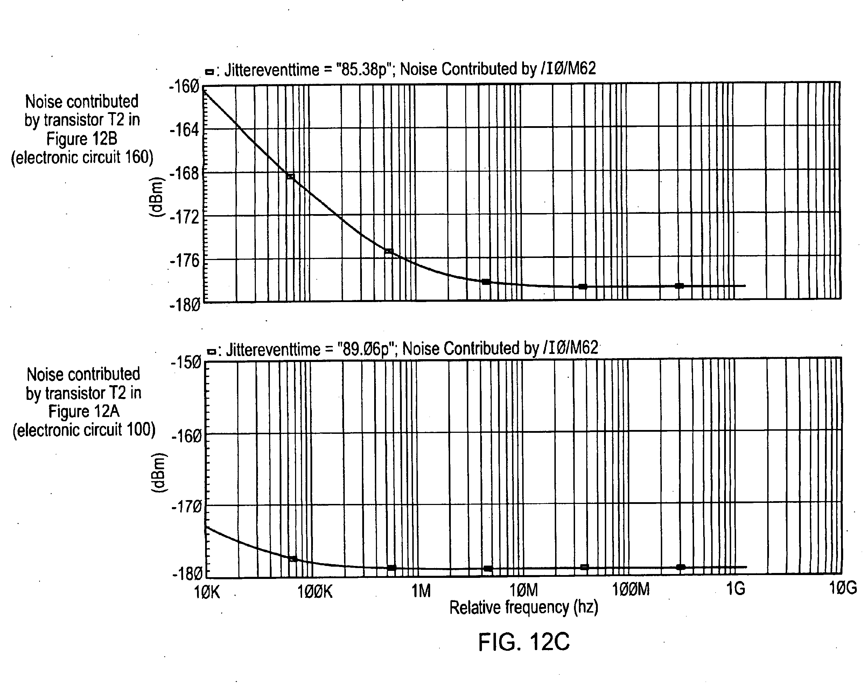

Figure 12C presents results obtained from simulations using the circuits of Figures 12A and 12B. The upper graph in Figure 12C shows the noise contributed by transistor T2 in Figure 12B (electronic circuit 160), and the lower graph in Figure 12C shows the noise contributed by the same transistor, transistor T2, in Figure 12A (electronic circuit 100). It can be therefore be appreciated that the 1/f noise present in transistor T2 is experienced in electronic circuit 160, and is substantially compensated for in electronic circuit 100. This is evidenced by the flatness (and small magnitude) of the trace in the lower graph of Figure 12C (particularly at low frequencies) as compared to the trace in the upper graph of Figure 12C.

As previously mentioned, provided that the charge packet of each discharging cycle for electronic circuit 100 is terminated with a constant voltage $V_{S-TERM} = V_{GATE} - V_{GS-TERM}$, the size of the charge packet $Q_{PK}$ will also remain constant as desired, assuming that C1 and $V_{START}$ remain constant. If the charge packet is terminated when the drain current flowing through transistor T2 drops to $i_{BIAS}$, the predetermined drain current at which the 1/f-noise compensation measurements are taken, then it can be appreciated from the above discussion that voltage $V_{S-TERM} = V_{GATE} - V_{GS-TERM}$ will indeed ideally remain constant and independent of 1/f noise. However, it is difficult to design control circuitry to cause the charge packet to be terminated at the drain current $i_{BIAS}$ which is not itself susceptible to 1/f noise.

One possibility is to terminate the charge packet at a different predetermined drain current, $i_{BIAS-2}$. This can be done because the 1/f noise compensation effectively causes the shape of the current waveform of the charge packet to be independent of 1/f noise. One possible value of $i_{BIAS-2}$ is therefore the value at which transistor T2 shuts off, i.e. zero. However, because in this case the condition for terminating the charge packet is the shutting off of T2, a problem arises, as follows.

As the discharging current flowing through the transistor T2 falls to zero, as transistor T2 approaches the shut-off point, its transconductance gm falls because its transconductance gm is a function of the square root of the drain current. The source resistance of transistor T2 is a function of the reciprocal of the transconductance, i.e. of 1/gm, and accordingly this resistance rises as the square root of the drain current falls. Accordingly, as the current in transistor T2 falls, so its rate of falling falls, such that the time for the transistor T2 to reach shut-off is relatively large. In the case of electronic circuit 100, which is intended to operate at a high rate (the input clocks may change at 2.5GHz or more), it is possible that the transistor T2 will not fully reach the shut-off point in each discharging cycle. In that case, it can be the input clocks that terminate each charge packet by beginning the next charging cycle.

Accordingly, in this case, any jitter in the input clocks can adversely affect the operation of the circuit. This can be understood as follows. If the input clocks were ideal, i.e. jitter-free, then the charge packets would be terminated after a fixed time period. Because the 1/f noise compensation effectively causes the shape of the current waveform of the charge packet to be independent of 1/f noise, this would provide a constant sized charge packet, effectively independent of 1/f noise. If instead the input clocks were not ideal, i.e. subject to jitter as suggested above, the jitter would be superimposed onto the charge packet size, that is, the size of the charge packets would vary with the jitter in the input clocks. This adverse effect can be reduced by using a monostable circuit to generate the input clocks based on a single edge (rising or falling) of an external clock signal, however any residual jitter in this monostable can still cause this problem.

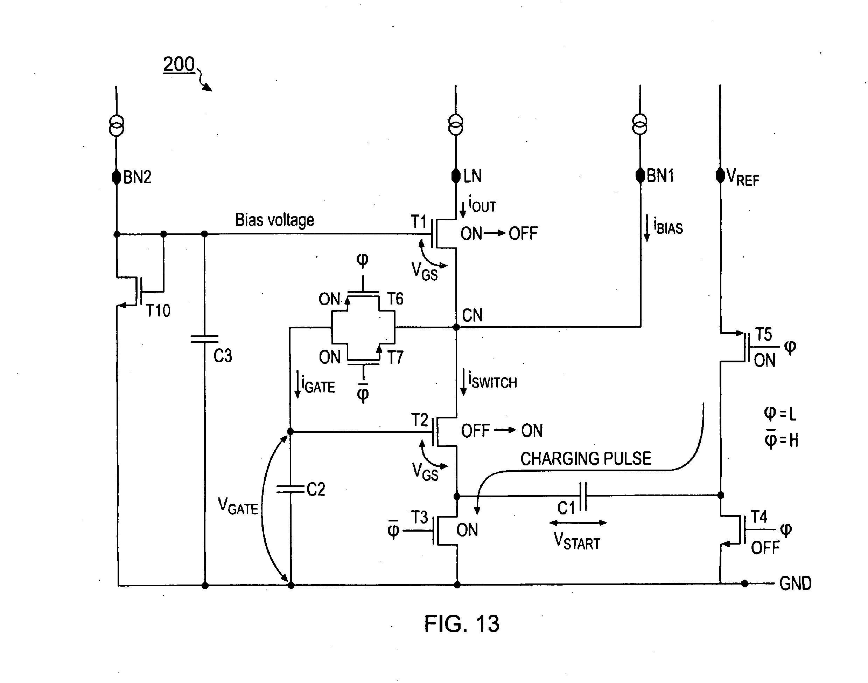

Figure 13 is a circuit diagram of an electronic circuit 200 embodying the present invention. Electronic circuit 200 is intended to overcome the above problem with electronic circuit 100. Electronic circuit 200 is identical to electronic circuit 100, except that transistors T8 and T9 have been omitted therefrom such that the first biasing node BN1 is directly connected to node CN.

Electronic circuit 200 receives the same complementary clock input signals φ and $\overline{φ}$ as electronic circuit 100. That is, the gate terminals of transistors T4, T5, and T6 are connected to receive clock input signal φ, and the gate terminals of transistors T3 and T7 are connected to receive clock input signal $\overline{φ}$.

Electronic circuit 200, like electronic circuit 100, operates as a charge pump. When φ = L the electronic circuit 200 undergoes a charging cycle, and when φ = H the electronic circuit 200 undergoes a discharging cycle, as follows. The intended use of electronic circuit 200 is (as for electronic circuit 100) to draw a fixed size charge packet $Q_{PK}$ from an external circuit via load node LN in each discharging cycle.

The states of the circuit elements of electronic circuit 200 in the charging cycle are shown in Figure 13. Because the first biasing node BN1 is directly connected to node CN in electronic circuit 200, its operation during the charging cycle is the same as the operation of electronic circuit 100 during the charging cycle, and accordingly no further explanation is provided.

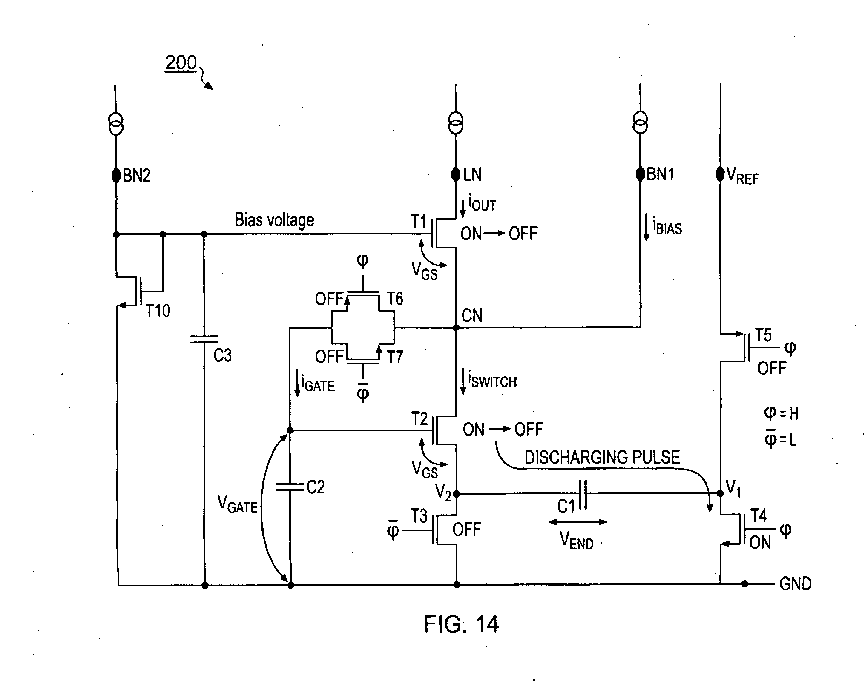

The states of the circuit elements of the electronic circuit 200 in the discharging cycle are shown in Figure 14. As can be seen from Figures 14 and 5, the states of the circuit elements of the electronic circuit 200 during the discharging cycle are the same as the states of the corresponding circuit elements of the electronic circuit 100 during the discharging cycle. Accordingly, the only difference is that the first biasing node BN1 remains connected to node CN.

The voltage level $V_1$ at the right-hand end of capacitor C1 was substantially at Vref at the end of the preceding charging cycle, and now drops towards 0V as it is connected to the power supply node GND via transistor T4. The rate at which that voltage level drops is determined by the switching time (on time, or slew) of transistor T4.

The voltage level $V_2$ at the left-hand end of capacitor C1 which was substantially at 0V at the end of the preceding charging cycle, drops below 0V due to the effect of the charge Q which is stored in that capacitor (and the potential difference $V_{START}$ stored across its plates).

Initially, T1 is off. As already mentioned, the source terminal of transistor T2 drops below GND, and transistor T2 therefore sees its gate-source voltage $V_{GS}$ increase because the voltage level at its gate terminal $V_{GATE}$ was stored on the capacitor C2 in the preceding charging cycle and that voltage level substantially remains so stored. Accordingly, assuming that the transistor T2 has reached a point at which it has turned on in the preceding charging cycle, transistor T2 remains on. This in turn causes the voltage level at node CN to decrease. Transistor T1 accordingly sees its gate-source voltage $V_{GS}$ increase too, because the bias voltage is substantially maintained at its gate terminal as discussed above. This gate-source voltage $V_{GS}$ increase for T1 turns it on. Accordingly, as for electronic circuit 100, a discharging path is created in electronic circuit 200 from the load node LN via the transistors T1 and T2, the capacitor C1 and the transistor T4 to the power supply node GND.

Once the discharging path has been created, the stored charge Q in the capacitor C1 causes a current to flow from the load node LN to the power supply terminal GND as a packet of charge is delivered from the load node LN to the capacitor C1 returning C1 towards an uncharged state. However, because biasing node BN1 is still connected to node CN, this flowing current includes the current $i_{BIAS}$ flowing from biasing node BN1.

It can be seen from Figure 14 that the discharging current $i_{SWITCH}$ flowing through the transistor T2 is as follows:

$$i_{SWITCH} = i_{OUT} + i_{BIAS}$$

such that

$$i_{OUT} = i_{SWITCH} - i_{BIAS}$$

As for electronic circuit 100, the discharging current in electronic circuit 200 causes the source voltage of the transistor T2 to begin to stop dropping and instead to begin to rise. The level to which the source voltage of the transistor T2 drops is again dependent on the gm value of that transistor, in combination with the on resistance of the transistor T4 already mentioned. These values may again be selected for example such that the source voltage of transistor T2 drops to around -0.6V, when Vref = 1.2V.

As the packet of charge is delivered from the load node LN to the capacitor C1, the voltage level $V_2$ at the left-hand end of capacitor C1 (the source voltage of the transistor T2), which had dropped below 0V to as mentioned above, begins to rise back towards and through 0V (GND), due to the current flow of the charge packet.

The voltage level $V_2$ at the left-hand end of C1 thus rises towards the point at which the gate-source voltage $V_{GS}$ for transistor T2 is equal to its threshold voltage $V_T$, at which point transistor T2 shuts off. In contrast to electronic circuit 100, however, the charge packet is not terminated by the input clocks, or by the transistor T2 reaching its shut-off point, as follows.

Because the first biasing node BN1 is connected to node CN, the biasing current contribution to the discharging current $i_{SWITCH}$ flowing through the transistor T2 remains constant. Accordingly, as the voltage level $V_2$ at the left-hand end of C1 rises, the current $i_{SWITCH}$ flowing through the transistor T2 reduces to the point where it is solely provided by the biasing current $i_{BIAS}$. At this point, the current $i_{OUT}$ drawn from the load node LN has reduced to zero, such that:

$$i_{OUT} = i_{SWITCH} - i_{BIAS} = 0$$

in which case

$$i_{SWITCH} = i_{BIAS}$$

As the voltage level $V_2$ at the left-hand end of C1 rises still further the current $i_{SWITCH}$ flowing through the transistor T2 reduces still further (only very fractionally) to the point where it is less than the biasing current $i_{BIAS}$. At this point, the part of the biasing current $i_{BIAS}$ entering node CN that does not flow through transistor T2 is effectively directed into the source terminal of transistor T1. Effectively, the voltage level at node CN rapidly rises due to the charging of parasitic capacitance present at that node and almost immediately shuts off cascode transistor T1. This terminates the charge packet. That is, the condition for terminating the charge packet in electronic circuit 200 is when $i_{SWITCH} = i_{BIAS}$.

Considering Figure 14 further, at the point at which the charge packet is terminated, the voltage level $V_1$ at the right-hand end of capacitor C1 is substantially GND, and the voltage level $V_2$ at the left-hand end of capacitor C1 is at $V_{GATE}$, minus the gate-source voltage $V_{GS}$ for transistor T2 at which $i_{SWITCH} = i_{BIAS}$. This gate-source voltage will be referred to as $V_{GS-IB}$. This voltage level $V_2$ is the source voltage of transistor T2 at charge-packet termination, i.e at which $i_{SWITCH} = i_{BIAS}$, hereinafter $V_{S-IB}$. Accordingly, the potential difference $V_{END}$ across capacitor C1 at the point at which the charge packet is terminated is equal to this $V_2$.

The change in potential difference $\Delta V$ across the capacitor C1 during the discharging cycle is therefore:

$$\Delta V = V_{START} - V_{END} = V_{START} - V_2 = V_{START} - V_{S\text{-}IB}$$

where

$$V_{S\text{-}IB} = V_{GATE} - V_{GS\text{-}IB}$$

The size of the charge packet $Q_{PK}$ delivered during the discharging cycle is therefore:

$$Q_{PK} = C1 \times \Delta V = C1 \times (V_{START} - V_{S\text{-}IB})$$

Because the discharging cycle terminates at the point when $i_{SWITCH} = i_{BIAS}$, the transconductance gm of transistor T2 is still relatively large, and the termination point is therefore reached relatively quickly. Furthermore, the cascode transistor provides an abrupt termination, as opposed to the gradual approach to termination in electronic circuit 100. Accordingly, electronic circuit 200 can be operated at the same switching speed as electronic 100 without the charge packet being terminated by the change in operating cycle. Therefore, any jitter in the input clock signals does not affect the size of the charge packets $Q_{PK}$ output by electronic circuit 200.

Based on the above, providing the discharging cycle is terminated at a constant $V_{S\text{-}IB}$, the size of the charge packet $Q_{PK}$ will be constant assuming that C1 and $V_{START}$ remain constant. Because $V_{S\text{-}IB} = V_{GATE} - V_{GS\text{-}IB}$, it will (similarly to before) be appreciated that if $V_{GATE}$ was held constant from one cycle to the next and there was no 1/f noise present in the circuit, then the size of the charge packet $Q_{PK}$ could be considered to be constant too.

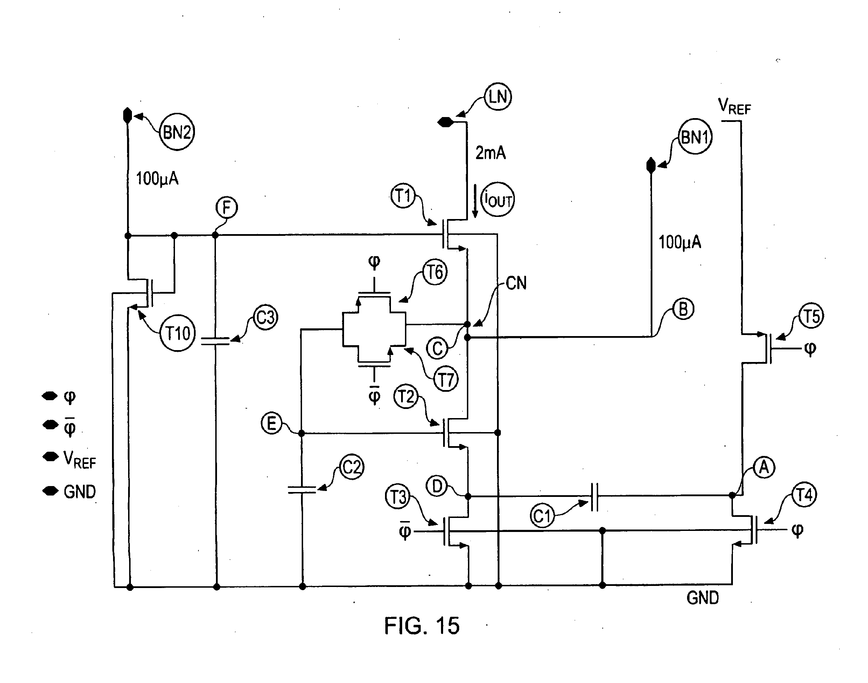

Figure 15 is a schematic diagram of the electronic circuit 200, used to simulate operation of the circuit. In order to show the correspondence between Figure 15 and Figures 13 and 14, the circuit elements and nodes in the schematic diagram of Figure 15 have been identified by circled references that correspond to the references used in Figures 13 and 14.

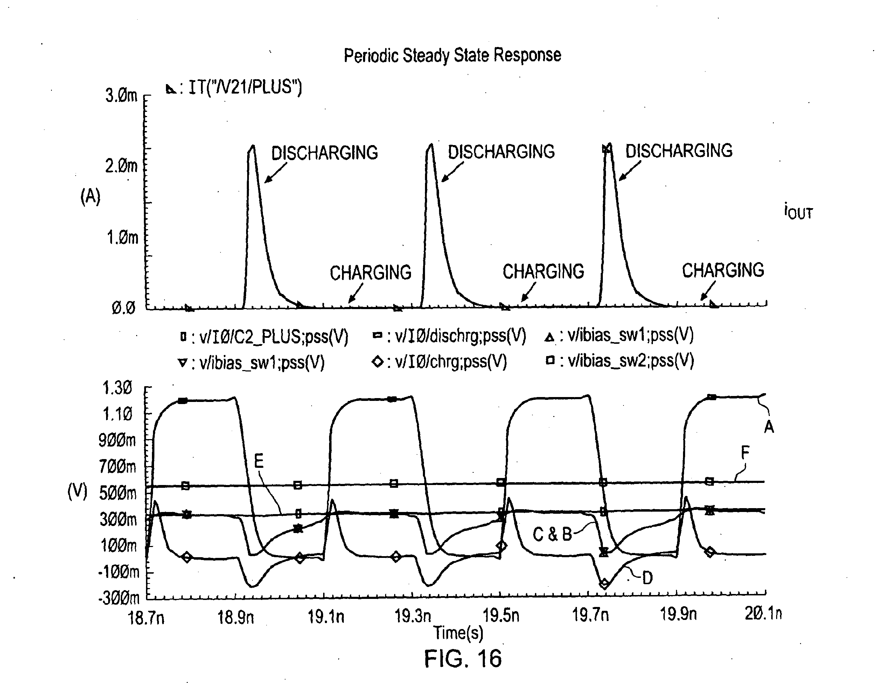

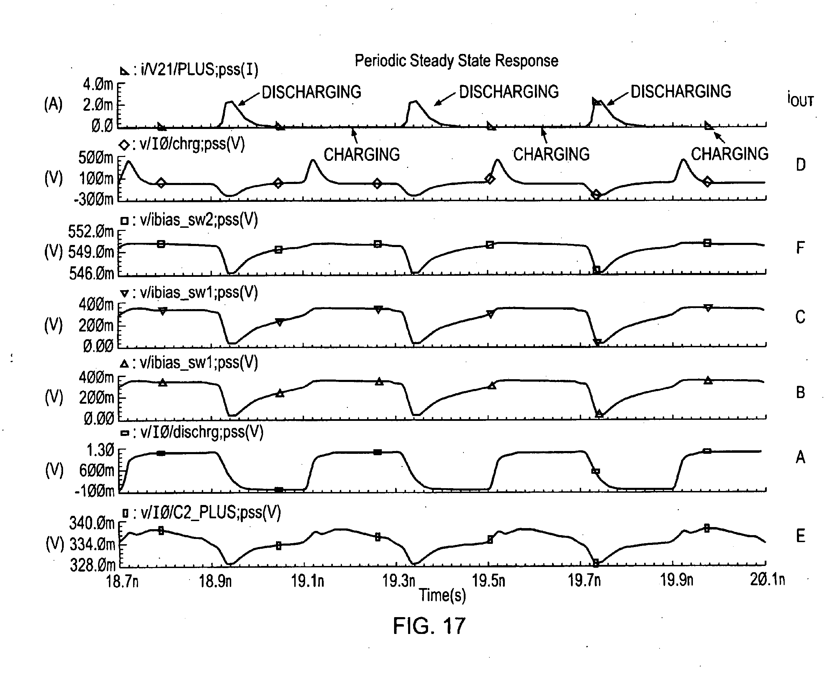

Further circled references have been entered into Figure 15 to assist understanding of Figures 16 and 17, which are discussed below. Figures 16 and 17 are equivalent to Figures 7 and 8, except that they relate to the circuit of Figure 15. Accordingly, the further circled reference entered into Figure 15 are the same as the further circled references entered into Figure 6, namely $i_{OUT}$, and A to F.

In Figure 16 (as in Figure 7), the output current $i_{OUT}$ results are shown in the upper graph, and the results for voltage levels A to F are shown together on the lower graph. Accordingly, the relationship between the different voltage levels A to F as the circuit alternates between charging and discharging cycles can be seen. In Figure 17 (as in Figure 8), the different results are shown on separate graphs, and so the shapes of the different result traces can be more clearly seen.

As can be seen from Figures 16 and 17, the electronic circuit 200 is intended to operate at a high rate. For example, it is envisaged that the input clocks φ and $\overline{φ}$ may change at 2.5GHz (as in the simulation) or more. The transistor T2 suffers from 1/f noise in the same was as in electronic circuit 100, and is particularly critical in the discharge path as (unlike the transistors T1 and T4) it is operating as an active device. The transistor T2 still controls the end point of the charge packet, whereas the transistors T1 and T4 are merely acting as passive resistors.

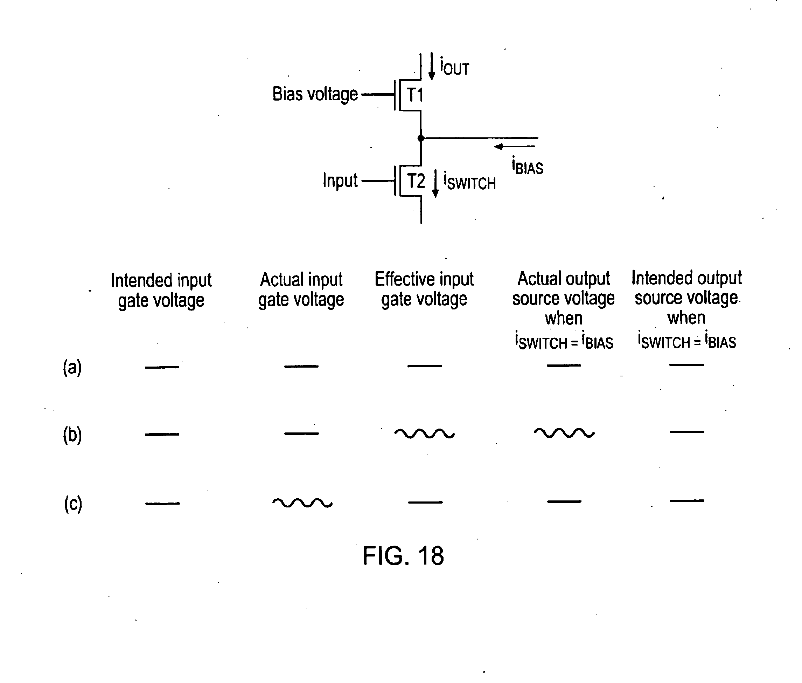

Figure 18 is a schematic diagram for explaining the effect of 1/f noise on the electronic circuit 200. It will be appreciated that Figure 18 is closely similar to Figure 9.

For ease of explanation, the transistors T1 and T2 of electronic circuit 200 are considered in isolation and in three different situations, namely (a), (b), and (c). As in Figure 9, transistor T2 receives a gate voltage as an input signal, i.e. $V_{GATE}$. The relevant output signal of transistor T2 is considered to be its source voltage $V_{S\text{-}IB}$ at the point at which the charge packet is terminated, i.e. when $i_{SWITCH} = i_{BIAS}$. In each situation, it is assumed that transistor T2 is passing a predetermined drain current in saturation, in this case conveniently $i_{BIAS}$.

As already mentioned, the intended use of electronic circuit 200 is to draw a fixed size charge packet $Q_{PK}$ from an external circuit via load node LN in each discharging cycle. As mentioned above, the size of the charge packet $Q_{PK}$ will be constant as long as the source voltage $V_{S\text{-}IB}$ is constant, assuming that C1 and $V_{START}$ remain constant. Also as already mentioned, $V_{S\text{-}IB} = V_{GATE} - V_{GS\text{-}IB}$. In a 1/f-noise free transistor, similarly to before, it could reasonably be assumed that, to achieve a constant $V_{S\text{-}IB}$, a constant $V_{GATE}$ from one cycle to the next can be applied to that transistor, becuase in that case the applied gate voltage necessary to achieve a particular source voltage in saturation while passing the predetermined drain current $i_{BIAS}$ should not vary over time. That is, in the absence of 1/f noise, the voltage $V_{GS\text{-}IB}$

necessary to pass the predetermined drain current $i_{BIAS}$ should not vary over time. Therefore, in each of the situations (a), (b), and (c) of Figure 18, the intended input gate voltage $V_{GATE}$ is assumed to be constant over successive cycles, and the intended output source voltage $V_{S-IB}$ similarly constant to obtain the desired fixed-size charge packet $Q_{PK}$.

Further explanation of Figure 18 is omitted, as the same considerations in respect of Figure 9 apply to Figure 18. Furthermore, the electronic circuit 200 has been designed to try to operate according to situation (c) in Figure 18, i.e. to try to reduce the effect of 1/f noise in transistor T2 on the output of the circuit, i.e. on the size of the charge packet $Q_{PK}$, in the same way as electronic circuit 100. Accordingly, the considerations in respect of Figures 10 and 11 apply to electronic circuit 200 as well as to electronic circuit 100.

It will be appreciated that the main advantage of electronic circuit 200 over electronic circuit 100 is thus as follows. As previously mentioned, provided that the charge packet of each discharging cycle for electronic circuit 200 is terminated with a constant voltage $V_{S-IB} = V_{GATE} - V_{GS-IB}$, the size of the charge packet $Q_{PK}$ will also remain constant as desired, assuming that C1 and $V_{START}$ remain constant. If the charge packet is terminated when the drain current flowing through transistor T2 drops to $i_{BIAS}$, the predetermined drain current at which the 1/f-noise compensation measurements are taken, then it can be appreciated from the above discussion that voltage $V_{S-IB} = V_{GATE} - V_{GS-IB}$ will indeed ideally remain constant and independent of 1/f noise. It will be appreciated that the charge packet is indeed terminated when the drain current flowing through transistor T2 drops to $i_{BIAS}$ promptly and sharply by cascade transistor T1. That is, electronic circuit 200 does not need to rely on the input clocks (with or without a monostable) to terminate the charge packet, as in electronic circuit 100. In electronic circuit 200, the charge packets are auto-terminated when the drain current flowing through transistor T2 drops to $i_{BIAS}$. Any jitter in the input clocks (with or without a monostable) does not now superimpose itself onto the size of the charge packets.

In order to demonstrate the ability of electronic circuit 200 to compensate for the 1/f noise effect in transistor T2, simulations have been carried out, as follows.

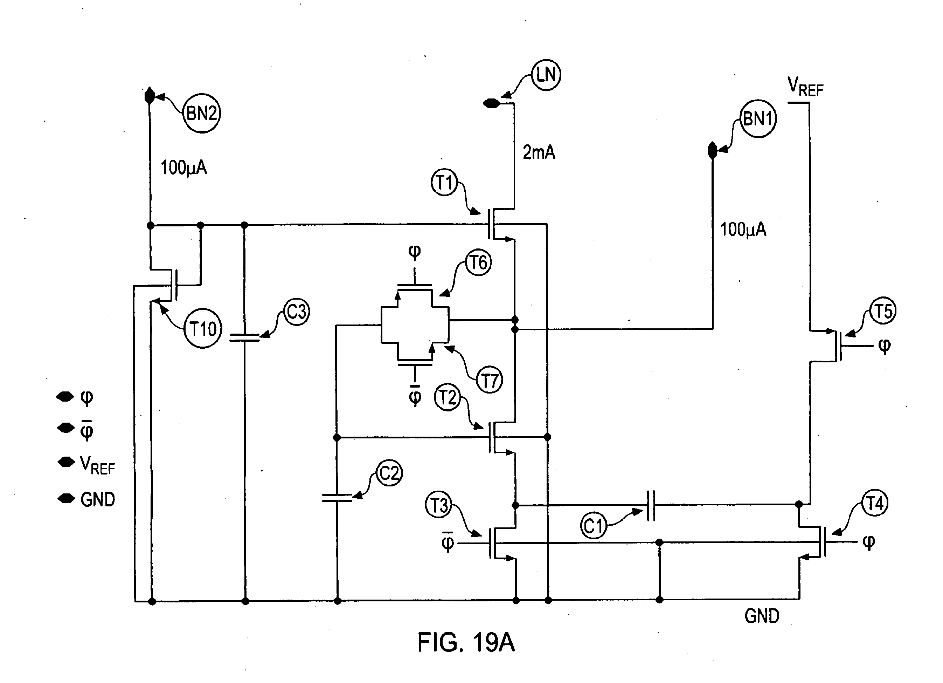

Figure 19A is a schematic diagram of the electronic circuit 200 used to simulate its operation. It will be appreciated that the schematic diagram of Figure 19A is closely similar to that of Figure 15, and accordingly the circuit elements have been labelled in the same way. Referring back to Figure 12B, electronic circuit 160 differs from electronic circuit 200 in a similar way as it differs from electronic circuit 100. That is, electronic circuit 160 is not designed to compensate for the 1/f noise effect in transistor T2, whereas electronic circuit 200 is designed to compensate for that 1/f noise effect. Accordingly, by comparing simulations of the Figure 19A and 12B circuits it is possible to appreciate the 1/f noise compensation provided by electronic circuit 200. Without duplicating description of Figure 12B, it will be appreciated that electronic circuit 160 has been designed to operate according to situation (b) in Figure 18, whereas electronic circuit 200 has been designed to operate according to situation (c) in Figure 18.

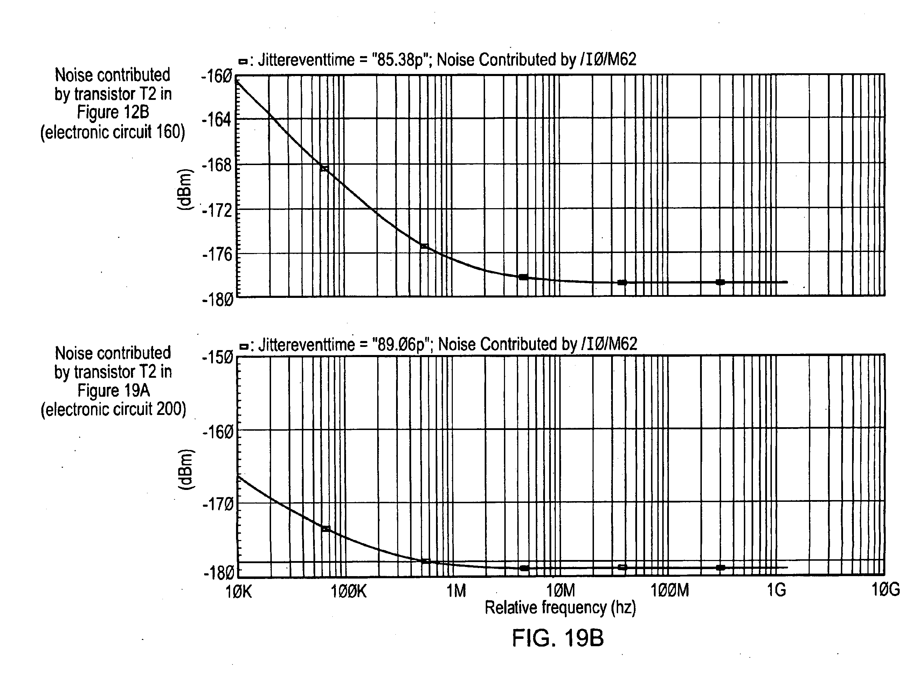

Figure 19B presents results obtained from simulations using the circuits of Figure 19A and 12B. The upper graph in Figure 19B shows the noise contributed by transistor T2 in Figure 12B (electronic circuit 160), and is thus identical to the upper graph in Figure 12C. The lower graph in Figure 19B shows the noise contributed by the same transistor, transistor T2, in Figure 19A (electronic circuit 200). It can be therefore appreciated that the 1/f noise present in transistor T2 is experienced in electronic circuit 160, and is substantially compensated for in electronic circuit 200. This is evidenced by the flatness (and small magnitude) of the trace in the lower graph of Figure 19B (particularly at low frequencies) as compared to the trace in the upper graph of Figure 19B.

By comparing the lower graph of Figure 19B with the lower graph of Figure 12C, it is possible to compare the 1/f noise compensation provided by electronic circuit 200 with that provided by electronic circuit 100.

The 1/f noise compensation performances of electronic circuits 100 and 200 are closely similar to one another, however the simulation results show that electronic circuit 100 performs slightly better than electronic circuit 200. However, the bidirectional switch formed by transistors T8 and T9 has a charge injection effect in electronic circuit 100 which generates wideband noise. The absence of this bidirectional switch in electronic circuit 200 reduces the wideband noise present for electronic circuit 200 as compared to the electronic circuit 100. Therefore, although electronic circuit 100 has slightly better 1/f noise compensation performance than electronic circuit 200, electronic circuit 200 performs better than electronic circuit 100 when both 1/f noise and such wideband noise contributions are taken into account. Also, as explained above, in electronic circuit 200 (as opposed to electronic circuit 100) any jitter in the input clocks does not affect the size of the charge packets.

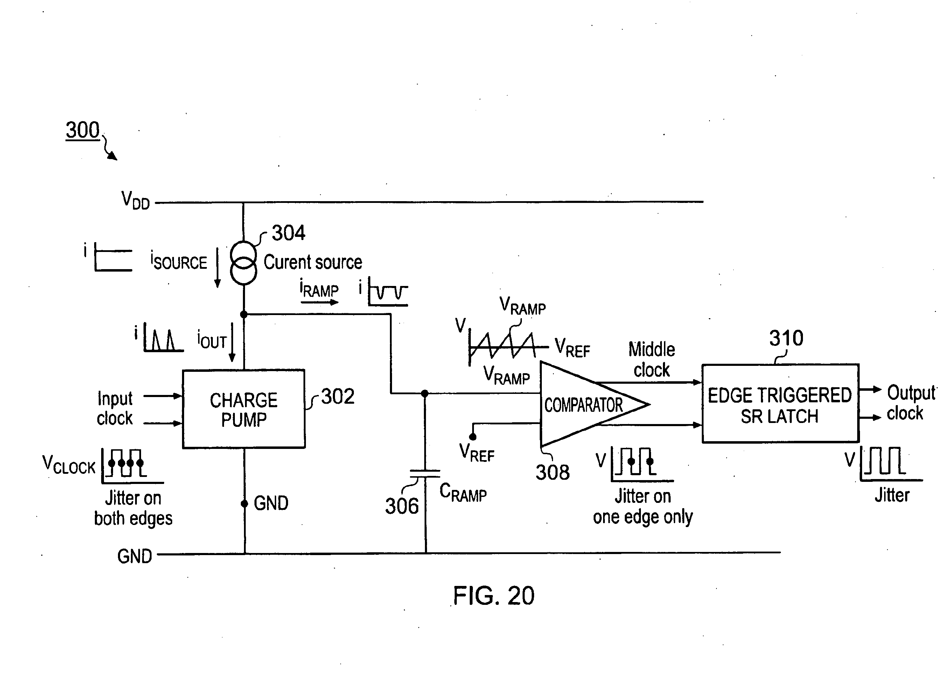

Figure 20 is a schematic diagram of an electronic circuit 300 embodying the present invention. Electronic circuit 300 comprises a charge pump 302, a current source 304, a capacitor 306, a comparator 308, and an edge-triggered SR latch 310.

Current source 304 and charge pump 302 are connected in series between a supply rail $V_{DD}$ and a supply rail GND. Charge pump 302 may be either one of the electronic circuits 100 and 200 described above, and is assumed so to be for further explanation. For simplicity, only the load node LN, the power supply node GND and the clock inputs of charge pump 302 are shown, and those parts of charge pump 302 correspond to the same parts of electronic circuits 100 and 200.

Electronic circuit 300 functions as an anti-jitter circuit according to the teaching set out in WO-A-97/30516. It is intended that the reader refer to WO-A-97/30516 to gain a full understanding of how electronic circuit 300 functions.

WO-A-97/30516 discloses a phase noise reduction circuit for reducing phase noise in an input pulse train consisting of pulses which are all of the same length and which, in the absence of phase noise, have a nominal frequency f, the phase noise reduction circuit including DC removal means for removing a DC level from the input pulse train, integrator means for integrating the input pulse train after a DC level has been removed therefrom by the DC removal means, and processing means for deriving from the integrated pulse train an output pulse train containing periodic transitions at half said nominal frequency.

It is appreciated by the present inventors that, although WO-A-97/30516 considers an input pulse train consisting of pulses which are all of the same length, in fact it is necessary to consider an input pulse train consisting of pulses which are all of the same area. In reference to electronic circuits 100 and 200 above, it is appreciated that importance has been placed on obtaining charge packets of the same size, which equates to a current waveform having spikes of the same area. Accordingly, embodiments of the present invention may employ a phase noise reduction circuit for reducing phase noise in an input pulse train consisting of pulses which are all of the same area and which, in the absence of phase noise, have a nominal frequency f, the phase noise reduction circuit including DC removal means for removing a DC level from the input pulse train, integrator means for integrating the input pulse train after a DC level has been removed therefrom by the DC removal means, and processing means for deriving from the integrated pulse train an output pulse train containing periodic transitions at half said nominal frequency.

Current source 304 provides a stable current $i_{SOURCE}$ into node LN of the charge pump 302. This node LN is also connected to an input terminal of comparator 308.

Capacitor 306 is connected between this input terminal of the comparator 308 and the supply rail GND. The other input terminal of the comparator is connected to a reference voltage supply Vref.

Charge pump 302 receives complementary clock signals, which are assumed to have jitter (phase noise) on both edges. Charge pump 302 accordingly draws charge packets from the node LN on one edge of the input clock signals as described above in respect of electronic circuits 100 and 200. Accordingly, current $i_{OUT}$ spikes for each such charge packet and current $i_{RAMP}$ flowing from node LN towards the comparator 308 has corresponding troughs as shown in Figure 20. Because electronic circuits 100 and 200 draw fixed-size charge packets (substantially free from 1/f noise), the troughs in current $i_{RAMP}$ are of a fixed area. Current $i_{RAMP}$ corresponds to the waveform in Figure 2a of WO-A-97/30516.

Capacitor 306 serves as an integrator with respect to current $i_{RAMP}$, and generates a ramping voltage waveform $V_{RAMP}$ at the connected input terminal of the comparator 308. During charging cycles, the charge pump 302 draws no current from the load node LN and accordingly the voltage across the capacitor 306 ramps up. During each discharging cycle a fixed packet of charge is taken from the load node LN by the charge pump 302, and this causes the voltage across the capacitor 306 to ramp down. Voltage waveform $V_{RAMP}$ corresponds to the waveform in Figure 2b of WO-A-97/30516.

Comparator 308 compares its two input signals $V_{RAMP}$ and Vref, and produces output clock signals (called middle clock in Figure 20) in which jitter is only present on one of the clock edges. The output signals of the comparator 308 correspond to the waveform in Figure 2c of WO-A-97/30516.

The output signals of the comparator 308 are input to the edge-triggered SR latch 310, which is set to trigger on the jitter free edge of its input signals. Accordingly, edge-triggered SR latch 310 outputs output clock signals which are free from jitter on both edges. The output signals of the edge-triggered SR latch 310 correspond to the waveform in Figure 2d of WO-A-97/30516.

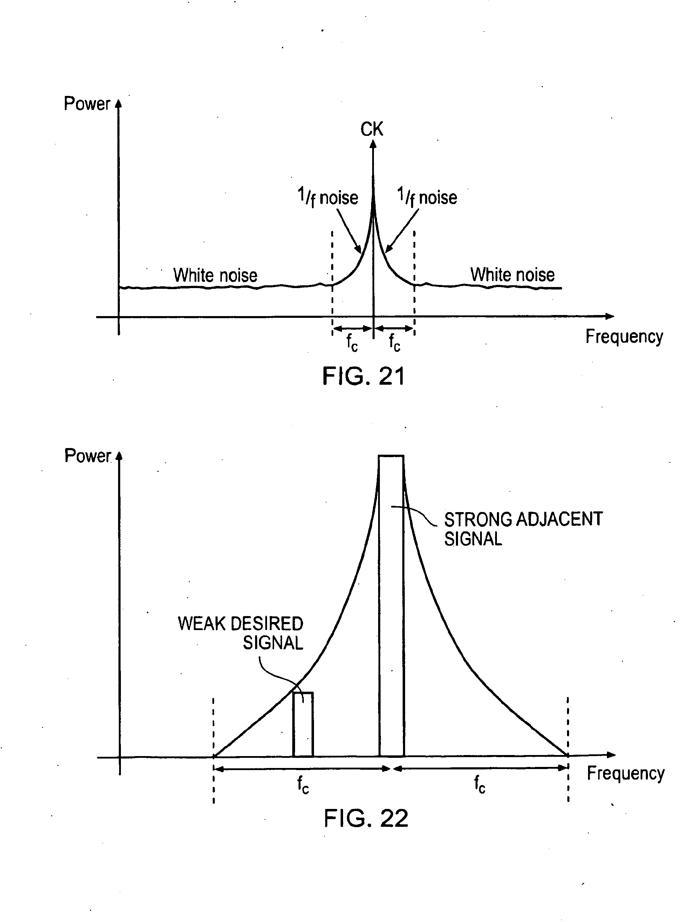

Importantly, because the charge packets drawn by charge pump 302 are of a fixed size and substantially unaffected by 1/f noise, the output clock signals of electronic circuit 300 are substantially free of 1/f noise. To show this significance, Figure 21 presents a frequency response of a clock signal which could be one of the output signals of electronic circuit 300 if charge pump 302 did not compensate for 1/f noise.

As can be seen from Figure 20, the clock signal CK has a "skirted" frequency profile, in which the effective edges of the skirt are defined by the 1/f corner frequency fc. That is, the skirt may have a width equal to twice the 1/f corner frequency fc.

Figure 21 presents an example frequency response which could be received if the clock signal of Figure 22 is used to sample a weak desired signal in the presence of a strong adjacent signal. After sampling, the effects of 1/f noise on the clock signal CK are superimposed on the sampled signals. This has been indicated in Figure 22 only in respect of the strong adjacent signal, and in an exaggerated fashion to show that this skirting may create significant interference for reception of the weak desired signal. As mentioned above, the 1/f corner frequency fc in for the transistor T2 in electronic circuits 100 and 200 may be as high as 10MHz. Accordingly, 1/f noise present on a clock signal used for sampling purposes may be a problem in most common radio systems (e.g. analogue radio, GSM, CDMA, WCDMA and WiFi).

The electronic circuit 300 may therefore, for example, be employed to clean up clock signals for use in an analogue-to-digital converter (ADC), or a digital-to-analogue converter (DAC), or in any (high-speed) circuit that requires a low-jitter clock that substantially does not suffer from 1/f noise. The present invention therefore extends to all of these circuits. The electronic circuits 100 and 200 (i.e. embodiments of the present invention) may be applied in all of these applications, and in any applications that require frequency-to-current or frequency-to-charge conversion, for example in voltage-controlled oscillators (VCOs), and in phase-locked-loops PLLs.

**Claims**

1. A charge-packet generation circuit (100) for generating a series of charge packets, the circuit comprising:

   an active electronic device (T2) whose output signal is dependent upon its input signal, whose output signal affects the size of said charge packets, and whose output signal is affected by 1/f noise due to an effect of the 1/f noise on such dependence of the output signal on the input signal;
   measurement means (C2) operable to obtain a noise measure, being a measure of the effect of the 1/f noise on said dependence; and
   compensation means (T6, T7, T8, T9) operable based upon said noise measure to influence operation of the circuit so as to tend to prevent the 1/f noise from affecting the size of said charge packets.

2. A charge-packet generation circuit as claimed in claim 1, wherein:

   the compensation means is operable to adapt said input signal so as to tend to prevent the 1/f noise from affecting the size of said charge packets.

3. A charge-packet generation circuit as claimed in any preceding claim, wherein:

   said noise measure is a measure of a difference between the output signal and the input signal of the active electronic device.

4. A charge-packet generation circuit as claimed in any preceding claim, wherein:

   said noise measure is a measure of a level of the input signal of the active electronic device which causes the output signal of the active electronic device to have a predetermined level.

5. A charge-packet generation circuit as claimed in any preceding claim, wherein said active electronic device is a field-effect transistor.

6. A charge-packet generation circuit as claimed in claim 5, wherein the compensation means is operable to adapt a gate voltage applied to the gate terminal of the field-effect transistor so as to tend to prevent the 1/f noise from affecting the size of said charge packets.

7. A charge-packet generation circuit as claimed in claim 5 or 6, wherein said noise measure is a measure of a gate-source voltage for said field-effect transistor at which that field-effect transistor passes a predetermined drain current when saturated.

8. A charge-packet generation circuit as claimed in any of claims 5 to 7, wherein the circuit is configured such that each said charge packet is terminated when the magnitude of the gate-source voltage for said field-effect transistor falls to a termination value from a higher value.

9. A charge-packet generation circuit as claimed in claim 8, wherein said termination value is a value reached after a predetermined time period from the beginning of the charge packet concerned.

10. A charge-packet generation circuit as claimed in claim 8 or 9, wherein said termination value is a value at which the field-effect transistor passes a particular drain current.

11. A charge-packet generation circuit as claimed in any preceding claim, wherein:

    the measurement means is operable to obtain a said noise measure during a measurement phase of operation of the circuit;

the compensation means is operable to carry out such influencing during a compensation phase of operation of the circuit; and

the compensation means is operable to carry out said influencing based upon the noise measure obtained during at least the preceding measurement phase.

12. A charge-packet generation circuit as claimed in claim 11, wherein the circuit is operable to alternate between said measurement and compensation phases based upon a control signal.

13. A charge-packet generation circuit as claimed in claim 11 or 12, wherein the circuit is operable to alternate between said measurement and compensation phases at a control frequency significantly greater than a 1/f corner frequency of the active electronic device.

14. A charge-packet generation circuit as claimed in any preceding claim, wherein:

said measurement means is configured to operate as a low-pass filter whose cut-off frequency is substantially larger than a 1/f corner frequency of the active electronic device such that the obtained noise measure tracks the effect of the 1/f noise on the said dependence.

15. A charge-packet generation circuit as claimed in claim 14 when read as appended to claim 13, wherein said cut-off frequency is substantially larger than the 1/f corner frequency and substantially smaller than said control frequency.

16. A charge-packet generation circuit as claimed in claim 14 or 15, wherein said cut-off frequency is substantially larger than the 1/f corner frequency and substantially smaller than a bandwidth of the circuit.

17. A charge-packet generation circuit as claimed in any preceding claim, wherein:

the circuit is operable alternately in charging and discharging phases;

the circuit is operable to store a charge during each charging phase and to draw a said charge packet from an external circuit during each discharging phase;

an output signal of the circuit is a current signal whose magnitude has a spike as each said charge packet is drawn from the external circuit; and

the output signal of the circuit is dependent upon the size of said charge packets such that the compensation means tends to prevent the 1/f noise from affecting the area of the spikes in the output signal of the circuit.

18. A charge-packet generation circuit as claimed in claim 17, configured such that said charge packets are of substantially the same size so that the area of said spikes is substantially constant from one discharging phase to the next.

19. A charge-packet generation circuit as claimed in claim 17 or 18 when read as appended to any of claims 11 to 13, wherein each said charging phase is or includes a measurement phase and wherein each said discharging phase is or includes a compensation phase.

20. A phase noise reduction circuit for reducing phase noise in an input pulse train consisting of pulses which are all of the same area and which, in the absence of phase noise, have a nominal frequency f, the phase noise reduction circuit comprising:

DC removal means for removing a DC level from the input pulse train;

integrator means for integrating the input pulse train after a DC level has been removed therefrom by the DC removal means;

processing means for deriving from the integrated pulse train an output pulse train containing periodic transitions at half said nominal frequency; and

a circuit as claimed in any of claims 17 to 19 connected to the DC removal means so that its output signal provides the input pulse train.

21. An analogue-to-digital converter comprising a charge-packet generation circuit or a phase noise reduction circuit, as the case may be, as claimed in any preceding claim.

22. A digital-to-analogue converter comprising a charge-packet generation circuit or a phase noise reduction circuit, as the case may be, as claimed in any of claims 1 to 20.

**Patentansprüche**

1. Ladungspaketerzeugungsschaltung (100) zum Erzeugen einer Serie von Ladungspaketen, welche Schaltung umfasst:

   eine aktive elektronische Vorrichtung (T2), deren Ausgangssignal von ihrem Eingangssignal abhängig ist, deren Ausgangssignal die Größe der Ladungspakete beeinträchtigt und deren Ausgangssignal durch 1/f--Rauschen auf Grund eines Effektes des 1/f-Rauschens auf solch eine Abhängigkeit des Ausgangssignals von dem Eingangssignal beeinträchtigt wird;
   ein Messmittel (C2), das betriebsfähig ist, um ein Rauschmaß zu erhalten, das ein Maß des Effektes des 1/f-Rauschens auf die genannte Abhängigkeit ist; und
   ein Kompensationsmittel (T6, T7, T8, T9), das auf der Basis des Rauschmaßes betriebsfähig ist, um die Operation der Schaltung so zu beeinflussen, dass sie dazu beiträgt, die Beeinträchtigung der Größe der Ladungspakete durch das 1/f-Rauschen zu verhindern.

2. Ladungspaketerzeugungsschaltung nach Anspruch 1, bei der:

   das Kompensationsmittel betriebsfähig ist, um das Eingangssignal so anzupassen, dass es dazu beiträgt, die Beeinträchtigung der Größe der Ladungspakete durch das 1/f-Rauschen zu verhindern.

3. Ladungspaketerzeugungsschaltung nach einem vorhergehenden Anspruch, bei der:

   das Rauschmaß ein Maß einer Differenz zwischen dem Ausgangssignal und dem Eingangssignal der aktiven elektronischen Vorrichtung ist.

4. Ladungspaketerzeugungsschaltung nach einem vorhergehenden Anspruch, bei der:

   das Rauschmaß ein Maß eines Pegels des Eingangssignals der aktiven elektronischen Vorrichtung ist, wodurch bewirkt wird, dass das Ausgangssignal der aktiven elektronischen Vorrichtung einen vorbestimmten Pegel hat.

5. Ladungspaketerzeugungsschaltung nach einem vorhergehenden Anspruch, bei der die aktive elektronische Vorrichtung ein Feldeffekttransistor ist.

6. Ladungspaketerzeugungsschaltung nach Anspruch 5, bei der das Kompensationsmittel betriebsfähig ist, um eine Gate-Spannung, die auf den Gate-Anschluss des Feldeffekttransistors angewendet wird, so anzupassen, dass sie dazu beiträgt, die Beeinträchtigung der Größe der Ladungspakete durch das 1/f-Rauschen zu verhindern.

7. Ladungspaketerzeugungsschaltung nach Anspruch 5 oder 6, bei der das Rauschmaß ein Maß einer Gate-Source-Spannung bei dem Feldeffekttransistor ist, bei dem der Feldeffekttransistor einen vorbestimmten Drain-Strom durchlässt, wenn er gesättigt ist.

8. Ladungspaketerzeugungsschaltung nach einem der Ansprüche 5 bis 7, bei der die Schaltung so konfiguriert ist, dass jedes genannte Ladungspaket abgeschlossen wird, wenn der Betrag der Gate-Source-Spannung bei dem Feldeffekttransistor von einem höheren Wert auf einen Abschlusswert fällt.

9. Ladungspaketerzeugungsschaltung nach Anspruch 8, bei der der Abschlusswert ein Wert ist, der nach einer vorbestimmten Zeitperiode ab Beginn des betreffenden Ladungspaketes erreicht wird.

10. Ladungspaketerzeugungsschaltung nach Anspruch 8 oder 9, bei der der Abschlusswert ein Wert ist, bei dem der Feldeffekttransistor einen besonderen Drain-Strom durchlässt.

11. Ladungspaketerzeugungsschaltung nach einem vorhergehenden Anspruch, bei der:

   das Messmittel betriebsfähig ist, um ein derartiges Rauschmaß während einer Messphase der Operation der Schaltung zu erhalten;
   das Kompensationsmittel betriebsfähig ist, um solch ein Beeinflussen während einer Kompensationsphase der Operation der Schaltung auszuführen; und
   das Kompensationsmittel betriebsfähig ist, um das Beeinflussen auf der Basis des Rauschmaßes auszuführen, das wenigstens während der vorhergehenden Messphase erhalten wurde.

12. Ladungspaketerzeugungsschaltung nach Anspruch 11, bei der die Schaltung betriebsfähig ist, um auf der Basis eines Steuersignals zwischen den Mess- und Kompensationsphasen zu alternieren.

13. Ladungspaketerzeugungsschaltung nach Anspruch 11 oder 12, bei der die Schaltung betriebsfähig ist, um mit einer Steuerfrequenz, die signifikant größer ist als die 1/f-Eckfrequenz der aktiven elektronischen Vorrichtung, zwischen den Mess- und Kompensationsphasen zu alternieren.

14. Ladungspaketerzeugungsschaltung nach einem vorhergehenden Anspruch, bei der:

das Messmittel konfiguriert ist, um als Tiefpassfilter zu arbeiten, dessen Grenzfrequenz wesentlich größer als die 1/f-Eckfrequenz der aktiven elektronischen Vorrichtung ist, so dass das erhaltene Rauschmaß dem Effekt des 1/f-Rauschens auf die genannte Abhängigkeit folgt.

15. Ladungspaketerzeugungsschaltung nach Anspruch 14 in Verbindung mit Anspruch 13, bei der die Grenzfrequenz wesentlich größer als die 1/f-Eckfrequenz und wesentlich kleiner als die Steuerfrequenz ist.

16. Ladungspaketerzeugungsschaltung nach Anspruch 14 oder 15, bei der die Grenzfrequenz wesentlich größer als die 1/f-Eckfrequenz und wesentlich kleiner als eine Bandbreite der Schaltung ist.

17. Ladungspaketerzeugungsschaltung nach einem vorhergehenden Anspruch, bei der:

die Schaltung alternierend in Ladungs- und Entladungsphasen betriebsfähig ist;
die Schaltung betriebsfähig ist, um während jeder Ladungsphase eine Ladung zu speichern und während jeder Entladungsphase ein derartiges Ladungspaket von einer externen Schaltung zu entnehmen;
ein Ausgangssignal der Schaltung ein Stromsignal ist, dessen Betrag eine Spitze hat, wenn jedes genannte Ladungspaket von der externen Schaltung entnommen wird; und
das Ausgangssignal der Schaltung von der Größe der Ladungspakete abhängig ist, so dass das Kompensationsmittel dazu beiträgt, die Beeinträchtigung des Bereiches der Spitzen in dem Ausgangssignal der Schaltung durch das 1/f-Rauschen zu verhindern.

18. Ladungspaketerzeuqungsschaltung nach Anspruch 17, die so konfiguriert ist, dass die Ladungspakete im Wesentlichen dieselbe Größe haben, so dass der Bereich der Spitzen von einer Entladungsphase zu der nächsten im Wesentlichen konstant ist.

19. Ladungspaketerzeugungsschaltung nach Anspruch 17 oder 18 in Verbindung mit einem der Ansprüche 11 bis 13, bei der jede genannte Ladungsphase eine Messphase ist oder enthält und bei der jede genannte Entladungsphase eine Kompensationsphase ist oder enthält.

20. Phasenrauschreduzierungsschaltung zum Reduzieren des Phasenrauschens in einer Eingangsimpulsfolge, die aus Impulsen gebildet ist, die alle denselben Bereich haben und die, bei fehlendem Phasenrauschen, eine Nennfrequenz f haben, welche Phasenrauschreduzierungsschaltung umfasst:

ein DC-Entfernungsmittel zum Entfernen eines DC-Pegels von der Eingangsimpulsfolge;
ein Integriermittel zum Integrieren der Eingangsimpulsfolge, nachdem ein DC-Pegel durch das DC-Entfernurigsmittel von ihr entfernt worden ist;
ein Verarbeitungsmittel zum Ableiten, von der integrierten Impulsfolge, einer Ausgangsimpulsfolge, die periodische Übergänge mit der halben Nennfrequenz enthält; und
eine Schaltung nach einem der Ansprüche 17 bis 19, die mit dem DC-Entfernungsmittel verbunden ist, so dass ihr Ausgangssignal die Eingangsimpulsfolge liefert.

21. Analog-Digital-Konverter mit einer Ladungspaketerzeugungsschaltung oder einer Phasenrauschreduzierungsschaltung, je nachdem, nach einem vorhergehenden Anspruch.

22. Digital-Analog-Konverter mit einer Ladungspaketerzeugungsschaltung oder einer Phasenrauschreduzierungsschaltung, je nachdem, nach einem der Ansprüche 1 bis 20.

**Revendications**

1. Circuit de génération de paquet de charge (100) destiné à générer une série de paquets de charge, le circuit comprenant :

   un dispositif électronique actif (T2) dont le signal de sortie dépend de son signal d'entrée, dont le signal de sortie influe sur la taille desdits paquets de charge, et dont le signal de sortie est touché par un bruit 1/f en raison d'un effet du bruit 1/f sur une telle dépendance du signal de sortie vis-à-vis du signal d'entrée ;
   un moyen de mesure (C2) servant à obtenir une mesure de bruit qui est une mesure de l'effet du bruit 1/f sur ladite dépendance ; et
   des moyens de compensation (T6, T7, T8, T9) servant, sur la base de ladite mesure de bruit, à influencer le fonctionnement du circuit de manière à avoir tendance à empêcher le bruit 1/f d'influer sur la taille desdits paquets de charge.

2. Circuit de génération de paquet de charge selon la revendication 1, dans lequel :

   les moyens de compensation servent à adapter ledit signal d'entrée de manière à avoir tendance à empêcher le bruit 1/f d'influer sur la taille desdits paquets de charge.

3. Circuit de génération de paquet de charge selon l'une quelconque des revendications précédentes, dans lequel :

   ladite mesure de bruit est une mesure d'une différence entre le signal de sortie et le signal d'entrée du dispositif électronique actif.

4. Circuit de génération de paquet de charge selon l'une quelconque des revendications précédentes, dans lequel :

   ladite mesure de bruit est une mesure d'un niveau du signal d'entrée du dispositif électronique actif qui amène le signal de sortie du dispositif électronique actif à avoir un niveau prédéterminé.

5. Circuit de génération de paquet de charge selon l'une quelconque des revendications précédentes, dans lequel ledit dispositif électronique actif est un transistor à effet de champ.

6. Circuit de génération de paquet de charge selon la revendication 5, dans lequel les moyens de compensation servent à adapter une tension de grille appliquée à la borne de grille du transistor à effet de champ de manière à avoir tendance à empêcher le bruit 1/f d'influer sur la taille desdits paquets de charge.

7. Circuit de génération de paquet de charge selon la revendication 5 ou 6, dans lequel ladite mesure de bruit est une mesure d'une tension grille-source pour ledit transistor à effet de champ à laquelle le transistor à effet de champ fait passer un courant drain lorsqu'il est saturé.

8. Circuit de génération de paquet de charge selon l'une quelconque des revendications 5 à 7, dans lequel le circuit est conçu de sorte que chaque dit paquet de charge soit terminé lorsque l'amplitude de la tension grille-source pour ledit transistor à effet de champ tombe à une valeur de fin depuis une valeur supérieure.

9. Circuit de génération de paquet de charge selon la revendication 8, dans lequel ladite valeur de fin est une valeur atteinte après une période prédéterminée depuis le début du paquet de charge en question.

10. Circuit de génération de paquet de charge selon la revendication 8 ou 9, dans lequel ladite valeur de fin est une valeur à laquelle le transistor à effet de champ fait passer un courant drain particulier.

11. Circuit de génération de paquet de charge selon l'une quelconque des revendications précédentes, dans lequel :

   le moyen de mesure sert à obtenir une dite mesure de bruit pendant une phase de mesure du circuit ;
   les moyens de compensation servent à réaliser une influence pendant une phase de compensation du circuit ; et
   les moyens de compensation servent à réaliser ladite influence sur la base de la mesure de bruit obtenue pendant au moins la phase de mesure précédente.

12. Circuit de génération de paquet de charge selon la revendication 11, dans lequel le circuit sert à alterner entre ladite phase de mesure et ladite phase de compensation sur la base d'un signal de commande.

**13.** Circuit de génération de paquet de charge selon la revendication 11 ou 12, dans lequel le circuit sert à alterner entre ladite phase de mesure et ladite phase de compensation à une fréquence de commande considérablement supérieure à une fréquence d'angle 1/f du dispositif électronique actif.

**14.** Circuit de génération de paquet de charge selon l'une quelconque des revendications précédentes, dans lequel :

ledit moyen de mesure est conçu pour servir de filtre passe-bas dont la fréquence de coupure est sensiblement supérieure à une fréquence d'angle 1/f du dispositif électronique actif de sorte que la mesure de bruit obtenue suive l'effet du bruit 1/f sur ladite dépendance.

**15.** Circuit de génération de paquet de charge selon la revendication 14 lorsqu'elle est lue comme étant annexée à la revendication 13, dans lequel ladite fréquence de coupure est sensiblement supérieure à la fréquence d'angle 1/f et sensiblement inférieure à ladite fréquence de commande.

**16.** Circuit de génération de paquet de charge selon la revendication 14 ou 15, dans lequel ladite fréquence de coupure est sensiblement supérieure à la fréquence d'angle 1/f et sensiblement inférieure à une bande passante du circuit.

**17.** Circuit de génération de paquet de charge selon l'une quelconque des revendications précédentes, dans lequel :

le circuit fonctionne en alternant phase de charge et phase de décharge ;
le circuit sert à stocker une charge pendant chaque phase de charge et à attirer un dit paquet de charge depuis un circuit extérieur pendant chaque phase de décharge ;
un signal de sortie du circuit est un signal de courant dont l'amplitude comporte une pointe lorsque chaque dit paquet de charge est attiré depuis le circuit extérieur ; et
le signal de sortie du circuit dépend de la taille desdits paquets de charge de sorte que les moyens de compensation aient tendance à empêcher le bruit 1/f d'influer sur la superficie des pointes dans le signal de sortie du circuit.

**18.** Circuit de génération de paquet de charge selon la revendication 17, conçu de sorte que lesdits paquets de charge soient sensiblement de la même taille de sorte que la superficie desdites pointes soit sensiblement constante d'une phase de décharge à l'autre.

**19.** Circuit de génération de paquet de charge selon la revendication 17 ou 18 lorsqu'elle est lue comme étant annexée à l'une quelconque des revendications 11 à 13, dans lequel chaque dite phase de charge est ou comprend une phase de mesure et dans lequel chaque dite phase de décharge est ou comprend une phase de compensation.

**20.** Circuit de réduction de bruit de phase destiné à réduire le bruit de phase dans un train d'impulsions d'entrée constitué d'impulsions qui ont toutes la même superficie et qui, en l'absence de bruit de phase, ont une fréquence nominale f, le circuit de réduction de bruit de phase comprenant :

un moyen de retrait DC destiné à retirer un niveau DC du train d'impulsions d'entrée ;
un moyen d'intégration destiné à intégrer le train d'impulsions d'entrée après le retrait d'un niveau DC par le moyen de retrait DC ;
un moyen de traitement destiné à dériver du train d'impulsions intégré un train d'impulsions de sortie contenant des transitions périodiques à la moitié de ladite fréquence nominale ; et
un circuit selon l'une quelconque des revendications 17 à 19 relié au moyen de retrait DC de sorte que son signal de sortie fournisse le train d'impulsions d'entrée.

**21.** Convertisseur analogique-numérique comprenant un circuit de génération de paquet de charge ou un circuit de réduction de bruit de phase, comme cela peut être le cas, selon l'une quelconque des revendications précédentes.

**22.** Convertisseur numérique-analogique comprenant un circuit de génération de paquet de charge ou un circuit de réduction de bruit de phase, comme cela peut être le cas, selon l'une quelconque des revendications 1 à 20.

EP 2 009 795 B1

FIG. 1

FIG. 2

EP 2 009 795 B1

FIG. 3

EP 2 009 795 B1

FIG. 4

EP 2 009 795 B1

FIG. 5

FIG. 6

FIG. 7

EP 2 009 795 B1

FIG. 8

Input ——|[ T2

Output

| Intended input gate voltage | Actual input gate voltage | Effective input gate voltage | Actual output source voltage | Intended output source voltage |
|:---:|:---:|:---:|:---:|:---:|
| (a) — | — | — | — | — |
| (b) — | — | $\sim\sim\sim$ | $\sim\sim\sim$ | — |
| (c) — | $\sim\sim\sim$ | — | — | — |

FIG. 9

EP 2 009 795 B1

FIG. 10

$$f_{CO} = \frac{1}{2\pi RC}$$

FIG. 11

$$f_{CO} = \frac{1}{2\pi RC}$$

FIG. 12A

EP 2 009 795 B1

FIG. 12B

Noise contributed
by transistor T2 in
Figure 12B
(electronic circuit 160)

□: Jittereventtime = "85.38p"; Noise Contributed by /IØ/M62

Noise contributed
by transistor T2 in
Figure 12A
(electronic circuit 100)

□: Jittereventtime = "89.Ø6p"; Noise Contributed by /IØ/M62

Relative frequency (hz)

FIG. 12C

FIG. 13

FIG. 14

EP 2 009 795 B1

FIG. 15

EP 2 009 795 B1

Periodic Steady State Response

FIG. 16

EP 2 009 795 B1

FIG. 17

FIG. 18

EP 2 009 795 B1

FIG. 19A

Noise contributed
by transistor T2 in
Figure 12B
(electronic circuit 160)

Noise contributed
by transistor T2 in
Figure 19A
(electronic circuit 200)

FIG. 19B

FIG. 20

EP 2 009 795 B1

FIG. 21

FIG. 22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9730516 A